# EUROPEAN PATENT APPLICATION

(11) **EP 4 752 150 A1**
(43) Date of publication of application: **03.06.2026**
(21) Application number: 24216799.7
(22) Date of filing: 02.12.2024
(51) Int. Cl.: C07F 5/02, C07B 59/00, C07F 7/08, C07F 9/6596, C09K 11/06, H05B 33/14, H10K 50/11

(54) **A BORON-CONTAINING COMPOUND AND AN ORGANIC LIGHT-EMITTING DEVICE INCLUDING THE SAME**

(71) Applicant: Noctiluca S.A., 81-100 Torun (PL)
(72) Inventor: Bosiak, Mariusz, 87-148 Papowo Torunskie (PL); Glodek, Marta, 95-035 Ozorków (PL); Ramanaskanda, Braveenth, 87-100 Torun (PL)
(74) Representative: Kowalkiewicz, Zuzanna

(57) **Abstract**

The subject of the invention is boron-containing compounds, a process for their preparation, an emissive layer comprising the same, an electroluminescent device, and their use. The invention belongs to the field of light-emitting devices, especially organic light-emitting devices (OLEDs).

## Description

### FIELD

The present disclosure generally relates to boron-containing compounds, a process for their preparation, an emissive layer comprising the same, an electroluminescent device, and their use. The invention belongs to the field of light-emitting devices.

### BACKGROUND

Organic Light Emitting Diodes (OLEDs) have become a key technology in display devices such as televisions, smartphones, and lighting systems. Compared to traditional plasma or LCD displays, OLEDs offer several advantages, including higher contrast, a wider colour gamut, and lower energy consumption.

An OLED consists of organic layers positioned between two electrodes: an anode and a cathode. One of these layers, known as an emissive layer, contains organic compounds that emit light upon excitation. In conventional OLEDs (first-generation), fluorescent emitters are used to produce light through the return of excited molecules to their ground singlet state. However, only 25% of excitons (excited molecules) in the singlet state can emit light, limiting the efficiency of this process to 25%.

The use of phosphorescent emitters (second-generation OLEDs), which contain heavy metals like iridium or platinum, allows for light emission from excited triplet states, theoretically raising efficiency to 100%. However, phosphorescent compounds have certain limitations, such as the need for costly substrates and low stability, associated with image "burn-in" effects from prolonged display of static elements.

Thermally Activated Delayed Fluorescence (TADF), used in third-generation OLED emitters, addresses the inefficient exciton utilization problem in OLEDs. Through this mechanism, both singlet and triplet states contribute to light emission, significantly enhancing the device's quantum efficiency. TADF compounds exhibit a small energy difference between the excited singlet and triplet states (ΔEST), enabling excitons to transition from the triplet excited state to the singlet state via reverse intersystem crossing (RISC). This phenomenon allows for emission efficiency close to 100%.

A recent advancement in OLED technology is hyperfluorescence, also known as fourth-generation OLEDs. Hyperfluorescence combines TADF emitters with traditional fluorescent emitters, enabling excitons to be generated by TADF molecules, which then transfer energy to fluorescent emitters. This mechanism produces a very narrow emission spectrum, high light intensity, and near - 100% quantum efficiency, while eliminating the need for heavy metals, thus reducing production costs. This technology increases brightness compared to commercial phosphorescent OLEDs, while also enhancing the device's external quantum efficiency.

### SUMMARY OF THE INVENTION

One object of the disclosure can be to provide novel compounds that exhibit luminescence and a process for their preparation. Another object of the disclosure is to describe an emissive layer comprising the compound described herein, as well as an electroluminescent device comprising such the emissive layer, the use of such device, and a consumer product.

The aim of this invention is to provide compounds with enhanced colour purity by reducing the Full Width at Half Maximum (FWHM) of the emission spectrum. This reduction in FWHM results in a narrower and more precise emission peak, which significantly improves colour purity in electroluminescent devices. By focusing on minimizing spectral broadening, the invention enables the production of compounds that contribute to brighter, more vivid, and accurately represented colours. This advancement is particularly beneficial in applications where high-quality colour representation is essential, such as in display technologies and advanced lighting systems. There is disclosed a boron-containing compound according to Formula I: 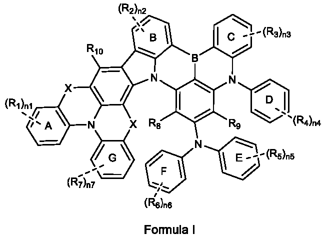 wherein:
R₁ - R₇, together or independently, are hydrogen, deuterium, halogen, cyano, nitro, hydrazine, hydrazone, hydroxyl, C₁-C₃₀ alkyl, C₂-C₃₀ alkenyl, C₂-C₃₀ alkynyl, C₁-C₁₀ alkoxy group, C₃-C₁₀ cycloalkyl, C₃-C₁₀ cycloalkenyl, C₅-C₂₀ heterocycloalkyl, C₅-C₂₀ heterocycloalkenyl group, C₃-C₁₀ cycloalkynyl group, C₅-C₂₀ heterocycloalkynyl group, C₆-C₆₀ aryl, C₄-C₆₀ heteroaryl group, C₅-C₆₀ aryloxy, C₄-C₆₀ heteroaryloxy group, C₂-C₆₀ ether group, C₆-C₆₀ thioaryl, C₄-C₆₀ heterothioaryl, C₁-C₁₀ amino, C₁-C₁₀ alkylamino, C₁-C₁₀ dialkylamino, C₆-C₆₀ arylamino, C₆-C₆₀ diarylamino, C₆-C₆₀ heteroarylamino group, C₆-C₆₀ heterodiarylamino group, C₄-C₆₀ non-aromatic fused polycyclic group, C₃-C₆₀ non-aromatic fused heteropolycyclic group or their deuterated analogues thereof;
**R₈ - R**_{**10**,} together or independently, are hydrogen, deuterium, halogen, cyano, nitro, hydrazine, hydroxyl, C₅-C₂₀ heterocycloalkyl, C₃-C₁₀ cycloalkynyl group, C₅-C₂₀ heterocycloalkynyl group, C₆-C₆₀ aryl, C₄-C₆₀ heteroaryl group, C₅-C₆₀ aryloxy, C₄-C₆₀ heteroaryloxy group, C₆-C₆₀ thioaryl, C₆-C₆₀ arylamino or their deuterated analogues.
**n₁, n₃**, **and n₇,** are the same as or different from each other, is an integer from 0 to 4,
**n₂** is an integer from 0 to 3,
**n₄** - **n₆,** are the same as or different from each other, is an integer from 0 to 5,
when **n₁** is an integer of 2, adjacent groups among **R₁** may be bonded to each other to form an aryl ring or a heteroaryl ring together with the **ring A** and at least one hydrogen atom in the ring thus formed may be further substituted,
when **n₂** is an integer of 2, adjacent groups among **R₂** may be bonded to each other to form an aryl ring or a heteroaryl ring together with the **ring B** and at least one hydrogen atom in the ring thus formed may be further substituted,
when **n₃** is an integer of 2, adjacent groups among **R₃** may be bonded to each other to form an aryl ring or a heteroaryl ring together with the **ring C** and at least one hydrogen atom in the ring thus formed may be further substituted,
when **n₄** is an integer of 2 or 4, adjacent groups among **R₄** may independently be bonded to each other to form an aryl ring or a heteroaryl ring together with the **ring D** and at least one hydrogen atom in the ring thus formed may be further substituted,
when **n₅** is an integer of or 4, adjacent groups among **R₅** may independently be bonded to each other to form an aryl ring or a heteroaryl ring together with the **ring E** and at least one hydrogen atom in the ring thus formed may be further substituted,
when **n₆** is an integer of 2 or 4, adjacent groups among **R₆** may independently be bonded to each other to form an aryl ring or a heteroaryl ring together with the **ring F** and at least one hydrogen atom in the ring thus formed may be further substituted,
when **n₇** is an integer of 2, adjacent groups among **R₇** may be bonded to each other to form an aryl ring or a heteroaryl ring together with the **ring G** and at least one hydrogen atom in the ring thus formed may be further substituted,
**X** is a single bond, O, S, Se, N-R₁₁, C(-R₁₁)₂, Si(-R₁₁)₂, P(=O),
**R₁₁** is each independently hydrogen, deuterium, halogen, cyano, nitro, hydrazine, hydrazone, C₁-C₃₀ alkyl, C₂-C₃₀ alkenyl, C₃-C₁₀ cycloalkyl, C₃-C₁₀ cycloalkenyl, C₁-C₁₀ heterocycloalkyl, C₆-C₆₀ aryl, C₅-C₂₀ aryloxy, C₅-C₂₀ heteroaryloxy group or their deuterated analogues.

In a preferred embodiment of the invention, the compound is selected from **Compound 1 - Compound 14** and 1 -423.

A process for obtaining the compound according to the invention, comprising a step reacting a compound according to Formula II 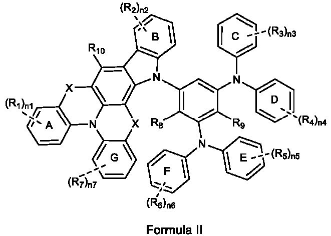 wherein
**R₁ - R₁₁, n₁- n₇, X, A - G** are the same as in Formula I;
with boron tribromide in an organic solvent solution in an inert gas atmosphere.

In a preferred embodiment of the invention, wherein the inert gas is nitrogen, carbon dioxide, argon, or other noble gas.

In a preferred embodiment of the invention, wherein the molar proportion of compound according to Formula II to boron tribromide is from 1.0:8.0 to 1.0:20.0.

In a preferred embodiment of the invention, wherein the solution is 1,2-dichlorobenzene, toluene, mesitylene, 1,2,4-trichlorobenzene, 2,4-dichlorotoluene, or 1,3,5-trimethylbenzene.

An emissive layer comprising the compound according to the invention.

An electroluminescent device comprising an anode, cathode, and the emissive layer according to the invention.

In a preferred embodiment of the invention, wherein the emissive layer comprises a Thermally Activated Delayed Fluorescence (TADF) compound.

In a preferred embodiment of the invention, wherein the emissive layer comprises the TADF compound selected from DBA-DI, DBA-DmlCz, DBA-DTMCz, TDBA-Ac, DBA-SAB, DBA-SAF, 3CzTB, TMCz-BO, TMCZ-3P, CNICCz, CNICtCz, M3CzB, MCz-BOBO, MCz-BSBS, CNBPCz, DMAC-DPS, DMA-ThX, DMTDAc, CzBPCN, TXADO-spiro-DMACF, MPAc-BN, MPAc-BS, MPAc-BO, MPAc-DiP-BS, PXZN-B, DMACN-B, PPCzTrz, sAc-DBB, sAc-sDBB, 4CzBN, 4TCzBN and 5CzBN.

A use of the device according to the invention as a display screen or illumination device, an electroluminescent display device, an organic photovoltaic device, or a sensing device.

A consumer product comprising the device according to the invention, wherein the product is selected from a flat panel display, a computer monitor, a medical monitor, a television, a billboard, a light for interior or exterior illumination/signalling, a heads-up display, a fully or partially transparent display, a flexible display, a laser printer, a telephone, a cell phone, tablet, a phablet, a personal digital assistant, a wearable device, a laptop computer, a watch, a backlight, a digital camera, a camcorder, a 3-D display, a virtual reality or augmented reality display, a vehicle, a video walls comprising multiple displays tiled together, a theatre, stadium screen, and a sign.

The compounds according to Formula 1 can be emitters of luminescence, including fluorescence, phosphorescence, or thermally activated delayed fluorescence.

TADF emitters mainly depend on intra molecular charge transfer, the emission spectra are notably broad and have poor colour purity to become applicable in next-generation displays. Therefore, a new OLED strategy known as hyper-fluorescence (HF) technology has been proposed to overcome such issues. Here, conventional TADF emitters act as TADF-sensitized host (TSH) for final emitters. Since TSH utilises singlet and triplet excitons, an effective energy conversion through long-range Förster resonance energy transfer to the final emitter is an essential phenomenon in HF technology. Therefore, spectral overlap between the emission of TSH and the absorption of the final emitter is requisite to make an efficient energy transfer. The final emitter can be either a simple fluorescence or multi-resonance type of fluorescence emitter.

Unexpectedly, the designed compounds according to the invention can also be employed as fluorescent dopant as a final emitter for effective hyper-fluorescence system to improve the colour purity in pure emission region.

### GENERAL DEFINITION OF TERMS AND SUBSTITUENTS

As used herein, the terms "or" and "and/or" include any and all combinations of one or more of the associated listed items. The term "or" is not an exclusive term, e.g., A or B means: A, B, or A and B. The expression "at least one" comprises at least one, two, three, four, five and more mentioned elements (etc.).

It should be understood that the terms "comprises," "comprising," "includes," "including," "has", "have," "having," "contains," "containing," and the like are intended to specify the presence of stated features, integers, steps, operations, elements, components, or combinations thereof in the disclosure, but do not preclude the presence or addition of one or more other features, integers, steps, operations, elements, components, or combinations thereof.

Certain chemical compound can have one or more hydrogen atoms of the compound replaced by one or more deuterium atoms including perdeuterated analogues. Further, it should be noted that the term "deuterated analogues " as used herein refers to compounds where at least one hydrogen atom has been replaced by a deuterium atom. The term "deuterated" as used herein alone or as part of a group, means substituted deuterium atoms. When a particular position is designated as holding deuterium (stated as "D" or "deuterium"), it is understood that the abundance of deuterium at that position is substantially greater than the natural abundance of deuterium, which is 0.015% (i.e., at least 50.1% incorporation of deuterium). The deuterated analogue of the present disclosure may be a fully or partially deuterium substituted derivative. For example, the deuterium substituted compound of the present disclosure can hold a fully or partially deuterium substituted alkyl, aryl or heteroaryl group. In one embodiment, the deuterium substituted compound of the present disclosure holds a fully or partially deuterium substituted alkyl group, e.g., -CD₃, CD₂, CD₃, -CD₂, and the like. In another embodiment, the deuterium substituted compound of the present disclosure holds a fully or partially deuterium substituted aryl, such as phenyl, e.g., CeDs or a fully or partially deuterium substituted heteroaryl, e.g., pyridyl-d₃, and the like.

The term "Ph" used herein refers to a phenyl group, the term "t-Bu" as used herein refers to a tert-butyl group, the term "iPr" used herein refers to an isopropyl group, and the term "OMe" used herein refers to a methoxy group.

Organic groups include both substituted and unsubstituted forms of such groups unless otherwise denoted.

The term "substituted" refers to at least one hydrogen replaced by hydrogen, deuterium, halogen, cyano, nitro, hydrazine, hydrazone, hydroxyl group, C₁-C₃₀ alkyl, C₂-C₃₀ alkenyl, C₂-C₃₀ alkynyl, C₁-C₁₀ alkoxy group, C₃-C₁₀ cycloalkyl, C₃-C₁₀ cycloalkenyl, C₅-C₂₀ heterocycloalkyl, C₅-C₂₀ heterocycloalkenyl group, C₃-C₁₀ cycloalkynyl group, C₅-C₂₀ heterocycloalkynyl group, , C₆-C₆₀ aryl group, C₄-C₆₀ heteroaryl group, C₅-C₆₀ aryloxy group, C₄-C₆₀ heteroaryloxy group, C₂-C₆₀ ether group, C₆-C₆₀ thioaryl group, C₄-C₆₀ heterothioaryl group, C₁-C₁₀ amino, C₁-C₁₀ alkylamino, C₁-C₁₀ dialkylamino, C₆-C₆₀ arylamino, C₆-C₆₀ diarylamino, C₆-C₆₀ heteroarylamino group, C₆-C₆₀ heterodiarylamino group, C₄-C₆₀ non-aromatic fused polycyclic group, C₃-C₆₀ non-aromatic fused heteropolycyclic group or their deuterated analogues thereof.

The term "C₁-C₃₀ alkyl group" as used herein refers to a linear or branched aliphatic saturated hydrocarbon group having 1 to 30 carbon atoms, and examples thereof include a methyl group, an ethyl group, a propyl group, an isopropyl group, a butyl group, an isobutyl group, a sec-butyl group, a tert-butyl group, a pentyl group, an isoamyl group, a neopentyl group, a hexyl group, 2-methylpentyl group, a 3-methylpentyl group, a heptyl group, a 4-methylhexyl group, a 2,2-dimethylpentyl group, an octyl group, a 3-methylheptyl group, a nonyl group, a 4-methyloctyl group, a 3-ethylheptyl group, a decyl group, a 2-methylnonyl group, a 3,3-dimethyloctyl group, an undecyl group, a dodecyl group, a tridecyl group, a tetradecyl group, a pentadecyl group, a hexadecyl group, a heptadecyl group, an octadecyl group, a nonadecyl group, an eicosyl group, a heneicosyl group, a docosyl group, a tricosyl group, a tetracosyl group, a pentacosyl group, a hexacosyl group, a heptacosyl group, an octacosyl group, a nonacosyl group, a triacontyl group and others, or their deuterated analogues thereof.

The term "C₂-C₃₀ alkenyl group" as used herein refers to a linear or branched aliphatic unsaturated hydrocarbon group having at least one carbon-carbon double bond in the middle or at the terminus of the C₂-C₃₀ alkyl group, and examples thereof include an ethenyl group, a propenyl group, a isopropenyl group, a butenyl group, a 2-methyl-1-propenyl group, a 2-methyl-2-butenyl group, a 3-methyl-2-butenyl group, a pentenyl group, a 4-methyl-2-butenyl group, a hexenyl group, a 2,3-dimethyl-2-butenyl group, a 4,4-dimethyl-1-butenyl group, a heptenyl group, a 3,4-dimethyl-3-butenyl group, an octenyl group, a 2,3-dimethyl-2-hexenyl group, a nonenyl group, a 2-methyl-3-heptenyl group, a decenyl group, a 4-ethyl-4-octenyl group, an undecenyl group, a dodecenyl group, a tridecenyl group, a tetradecenyl group, a pentadecenyl group, a hexadecenyl group, a heptadecenyl group, an octadecenyl group, a nonadecenyl group, an eicosenyl group, a heneicosenyl group, a docosenyl group, a tricosenyl group, a tetracosenyl group, a pentacosenyl group, a hexacosenyl group, a heptacosenyl group, an octacosenyl group, a nonacosenyl group, a triacontenyl group and others, or their deuterated analogues thereof.

The term "C₂-C₃₀ alkynyl group" as used herein refers to a linear or branched aliphatic unsaturated hydrocarbon group having at least one carbon-carbon triple bond in the middle or at the terminus of the C₂-C₃₀ alkynyl group, and examples thereof include an ethynyl group, and a propynyl group, a butynyl group, a 3-methyl-1-propynyl group, a pentynyl group, a 3-ethyl-2-butynyl group, a hexynyl group, a 3,3-dimethyl-1-butynyl group, a heptynyl group, a 3-propyl-1-pentynyl group, an octynyl group, a 3,3-dimethyl-4-hexynyl group, a nonynyl group, a 3,3-dimethyl-4-heptynyl group, a decynyl group, a 2-ethyl-3-octynyl group, an undecynyl group, a dodecynyl group, a tridecynyl group, a tetradecynyl group, a pentadecynyl group, a hexadecynyl group, a heptadecynyl group, an octadecynyl group, a nonadecynyl group, an eicosynyl group, a heneicosynyl group, a docosynyl group, a tricosynyl group, a tetracosynyl group, a pentacosynyl group, a hexacosynyl group, a heptacosynyl group, an octacosynyl group, a nonacosynyl group, a triacontynyl group and others, or their deuterated analogues thereof.

The term "C₁-C₁₀ alkoxy group" as used herein refers to an alkyl group which is singularly bonded to oxygen forming thus R-O-. The examples thereof include a methoxy group, an ethoxy group, and an isopropyloxy group, a propoxy group, a butoxy group, a tert-butoxy group, a sec-butoxy group, an iso-butoxy group, a pentoxy group, an iso-amyloxy group, a neo-pentoxy group, a hexoxy group, a heptoxy group, an octoxy group, a nonoxy group, a decoxy group, and others, or their deuterated analogues thereof.

The term "C₃-C₁₀ cycloalkyl group" as used herein refers to a monocyclic or polycyclic and non-aromatic saturated group that has 3 to 10 carbon atoms. When the C₃-C₁₀ cycloalkyl group includes two or more rings, the rings may be fused to each other. The examples thereof include a cyclopropyl group, a cyclobutyl group, a cyclopentyl group, a cyclohexyl group, and a cycloheptyl group, a cyclooctyl group, a cyclononyl group, a cyclodecyl group and others, or their deuterated analogues thereof.

The term "C₅-C₂₀ heterocycloalkyl group" as used herein refers to a cycloalkyl group having at least one heteroatom selected from N, O, Si, P, and S as a ring-forming atom and 5 to 20 carbon atoms. When C₅-C₂₀ heterocycloalkyl group includes two or more rings, the rings may be fused to each other. The examples thereof include a 1,2,3,4-oxatriazolidinyl group, a tetrahydrofuranyl group, and a tetrahydrothiophenyl group, a pyrrolidinyl group, an oxetanyl group, a thiiranyl group, a piperidinyl group, an azetidinyl group, a silacyclopropyl group, a furan group, a pyridinyl group, a dithianyl group, a phospholanyl group, a thiazolyl group, a siloxanyl group, a morpholinyl group, an oxazolyl group, a thiophenyl group, and an aziridinyl group, a tetrahydropyranyl group, a silacyclohexyl group, a phosphabicycloheptyl group and others, or their deuterated analogues thereof.

The term "C₃-C₁₀ cycloalkenyl group" used herein refers to a monocyclic or polycyclic and non-aromatic unsaturated group that has 3 to 10 carbon atoms and at least one carbon-carbon double bond in the ring thereof. When the C₃-C₁₀ cycloalkenyl group includes two or more rings, the rings may be fused to each other. The examples thereof include a cyclopropenyl group, a cyclobutenyl group, a cyclopentenyl group, a cyclohexenyl group, a cycloheptenyl group, a cyclooctenyl group, a cyclononenyl group, a cyclodecenyl group and others, or their deuterated analogues thereof.

The term "C₅-C₂₀ heterocycloalkenyl group" as used herein refers to a cycloalkenyl group that has at least one heteroatom selected from N, O, Si, P, and S as a ring-forming atom, having 5 to 20 carbon atoms, and at least one double bond in its ring. When the C₁-C₂₀ heterocycloalkenyl group includes two or more rings, the rings may be fused to each other. The examples of thereof include a 4,5-dihydro-1,2,3,4-oxatriazolyl group, a 2,3-dihydrofuranyl group, a 2,3-dihydrothiophenyl group, a pyrrolenyl group, a furanyl group, a thiophenyl group, a pyrrolopyridenyl group, an oxetanyl group, an azetidinyl group, a dioxasilolanyl group, a phospholanyl group, a pyrrolizidinyl group, an oxepinyl group, a thiepinyl group, a silacyclohexenyl group, a piperidinylidene group, an oxocyclooctenyl group, an azononacyclohexenyl group and others, or their deuterated analogues thereof.

The term "C₃-C₁₀ cycloalkynyl group" used herein refers to a monocyclic or polycyclic and non-aromatic unsaturated group that has 3 to 10 carbon atoms and at least one carbon-carbon triple bond in the ring thereof. When the C₃-C₁₀ cycloalkynyl group includes two or more rings, the rings may be fused to each other. The examples thereof include a cyclopropynyl group, a cyclobutynyl group, a cyclopentynyl group, a cyclohexynyl group, a cycloheptynyl group, a cyclooctynyl group, a cyclononylyl group, a cyclodecynyl group and others, or their deuterated analogues thereof.

The term "C₅-C₂₀ heterocycloalkynyl group" as used herein refers to a cycloalkynyl group that has at least one heteroatom selected from N, O, Si, P, and S as a ring-forming atom, having 5 to 20 carbon atoms, and at least one triple bond in its ring. When the C₅-C₂₀ heterocycloalkynyl group includes two or more rings, the rings may be fused to each other. The examples thereof include a pyridinylcyclopropynyl group, an oxazolylcyclobutynyl group, a thiophenylcyclopentynyl group, a silylcyclohexynyl group, a phosphacycloheptynyl group, a pyrazinylcyclooctynyl group, an oxacyclononynyl group, a thiasilacyclodecynyl group, an isoxazolylcycloheptenyl group, a pyrimidinylcyclopentadienyl group, a triazinylcyclohexadienyl group, a phosphoranylpyridinylcycloheptenyl group, an oxathiacyclononadienyl group, a silylpyrazinylcyclooctadienyl group, a pyridazinylcyclooctatrienyl group, an isothiazolylsilylcyclononatrienyl group, a thiophenylphosphacyclodecatrienyl group, a pyrimidinylsilylcycloheptadienyl group, an oxazinylphosphoranylcyclodecadienyl group, a silylthiasilacyclohexatrienyl group and others, or their deuterated analogues thereof.

The term "C₆-C₆₀ aryl group" as used herein refers to a carbocyclic aromatic group having 6 to 60 carbon atoms. When the C₆-C₆₀ aryl group includes two or more rings, the rings may be fused to each other. The examples thereof include a phenyl group, a naphthyl group, an anthracenyl group, a phenanthrenyl group, a pyrenyl group, a chrysenyl group, a biphenyl group, a triphenylenyl group, a fluorenyl group, a perylenyl group, a coroneneovalenyl group, a dibenzo[a,e]pentalenyl group, a tetrabenzo[a,c,f,h]pentaphenyl group, a hexabenzo[a,c,f,h,k,n]pentadecaphenyl group, an octabenzo[a,c,f,h,k,n,q,u]icosaphenyl group, a toluyl group, a xylyl group, a diphenylmethyl group, a terphenyl group and others, or their deuterated analogues thereof.

The term "C₄-C₆₀ heteroaryl group" as used herein refers to an aryl group having at least one heteroatom selected from N, O, Si, P, and S as a ring-forming atom, and having 4 to 60 carbon atoms. When the C₄-C₆₀ heteroaryl group includes two or more rings, the rings may be fused with each other. The examples thereof include a pyrimidinyl group, a pyrazinyl group, a pyridazinyl group, a triazinyl group, a quinolinyl group, an isoquinolinyl group, a furan-2-yl group, a thiophen-3-yl group, an imidazol-4-yl group, a thiazol-2-yl group, an oxazol-5-yl group, a pyrrole-2-yl group, an indol-3-yl group, a benzofuran-4-yl group, a benzothiophen-2-yl group, a benzimidazol-1-yl group, a benzothiazol-4-yl group, an isoxazol-3-yl group, a pyridin-4-ylmethyl group, a quinoxalin-2-yl group, a naphtho[1,2-d]imidazol-4-yl group, a tetrazol-1-yl group, a 1,2,3-triazol-4-yl group, a pyridin-2-ylmethoxy group, a thieno[2,3-c]pyridin-4-yl group, a 3,4-dihydro-2H-pyran-2-yl group, a 1,3-dioxol-2-yl group, a pyrazolo[1,5-a]pyridin-3-yl group, a benzofuran-2-ylmethyl group, a carbazole group, an indolocarbazole group, a phenoxazine group, a phenothiazine group, a benzimidazoquinazoline group, a pyridocarbazole group, a pyrrolopyrazine group, a quinoxaline-2,3-dione group, an isoxazole-3,5-dione group, an indole-3-carboxylic acid group, a dibenzofuranone group, a pyrroloquinoxaline group, an imidazo[1,2-a]pyrimidine group, a thiazolo[4,5-d]pyrimidine group, a benzothiazole-5-sulfonamide group, a 1H-pyrazolo[3,4-b]quinolin-3-amine group, a furo[3,2-c]pyridin-4(5H)-one group, a 1,3-dihydro-2H-indol-2-one group, a 2H-indazole-3-carboxylic acid group, a pyrazolo[1,5-a]pyrimidin-3-amine group, a 3H-indole-4-carbonitrile group, a benzoxazin-3-one group, a benzothiophene-2-carboxylic acid group, an isothiazole-3-carboxylic acid group, a pyrido[2,3-b]pyrazin-7-one group, a 3H-quinazolin-4-one group, a benzofurazan-5-amine group, a 1,2,4-triazolo[4,3-a]pyridine group, a 1,3,4-oxadiazole-2(3H)-thione group, a 2H-thiopyran-4,6-dione group, a pyrrolo[1,2-a]quinoxaline-4,7-dione group, a silylpyridine group, a phosphorylpyrazole group, an oxiranylpyrimidine group, a thioxanthyl group, a siloxazinyl group, a phosphonaphthyl group, a dioxaphenanthrenyl group, a thiophenylsiloxane group, an oxatriazinyl group, a silylpyrrole-2-carboxylic acid group, a phosphinophenoxazine group, a silathiazolyl group, an oxadithienyl group, a phosphabenzimidazole group, a silaquinolinyl group, an oxepino[2,3-b]pyridinyl group, a dioxaphenanthrenylpyrazinyl group, a phosphorothiazolidinyl group, a silaisoxazolyl group, an oxazolidinylpyridyl group and others, or their deuterated analogues thereof.

The term "C₅-C₆₀ aryloxy group" as used herein refers to an aryl which is singularly bonded to oxygen forming thus Ar-O-. The examples thereof include a methoxyphenyl group, an ethoxyphenyl group, a propoxyphenyl group, an isopropoxyphenyl group, a butoxyphenyl group, a pentoxyphenyl group, a hexoxyphenyl group, a heptoxyphenyl group, an octoxyphenyl group, a nonoxyphenyl group, a decoxyphenyl group, a dodecoxyphenyl group, a hexadecoxyphenyl group, a triacontaoxyphenyl group, a hexacontaoxyphenyl group, a phenylmethoxy group, a naphthoxy group, a biphenyloxy group, an anisoyloxy group, a toluoyloxy group, a xylyloxy group, a benzoyloxy group, a napththoyloxy group, an anthryloxy group, a perylenyloxy group, a fluorenyloxy group, a triphenyloxy group, a phenoxyphenyl group, a naphthoxyphenyl group, a pyrenyloxy group and others, or their deuterated analogues thereof.

The term "C₄-C₆₀ heteroaryloxy group" as used herein refers to an aryloxy group having a at least one heteroatom selected from N, O, Si, P, and S as a ring-forming atom, and having 4 to 60 carbon atoms. The examples thereof include a pyridinyloxy group, a furanoyloxy group, a thiophenoyloxy group, a siloxanoyloxy group, a phosphinoyloxy group, a pyrimidinyloxy group, a pyrazinyloxy group, a thiazolinyloxy group, an isoxazolinyloxy group, a benzoxazinoyloxy group, a benzothiazolinyloxy group, an imidazolinyloxy group, a pyridazinyloxy group, a silathiazolinyloxy group, an isothiazolinyloxy group, an oxazolinyloxy group, a silabenzoxazinoyloxy group, a phosphabenzothiazolinyloxy group, a dibenzofuranyloxy group, a silaisoxazolinyloxy group and others.

The term "C₂-C₆₀ ether group" as used herein refers to a group containing an ether group - an oxygen atom connected to two selected from: alkyl, alkenyl, alkynyl, and aryl group, where the ether group has 2 to 60 carbon atoms. The examples thereof include: a methyl ether group, an ethyl ether group, an isopropyl ether group, a tert-butyl ether group, a phenyl ether group, an anisyl ether group, a benzyl ether group, an allyl ether group, a methoxyethyl ether group, an ethoxyethyl ether group, a methylphenyl ether group, an ethylphenyl ether group, an isobutyl ether group, a cyclohexyl ether group, a methoxymethyl ether group, an ethoxymethyl ether group, a propyl ether group, a butyl ether group, a pentyl ether group, a hexyl ether group, a methoxypropyl ether group, an ethoxypropyl ether group, a dimethyl ether group, a diethyl ether group, a dipropyl ether group, a dibutyl ether group, a dipentyl ether group, a methoxyisopropyl ether group, an ethoxyisopropyl ether group, a methoxy*tert-*butyl ether group, a methoxyphenyl ether group, an ethoxyphenyl ether group, a p-tolyl ether group, an o-anisyl ether group, a naphthyl ether group, a biphenyl ether group, a 2-methylphenyl ether group, a 4-ethylphenyl ether group, a 3-methoxyphenyl ether group, a 2,4-dimethylphenyl ether group, a 3,5-diethylphenyl ether group, a 2,4,6-trimethylphenyl ether group, a 2,3-dimethoxyphenyl ether group, a 2,4-diethylphenyl ether group, a 4-methoxynaphthyl ether group, a 3,4-diphenylnaphthyl ether group and others, or their deuterated analogues thereof.

The term "C₆-C₆₀ thioaryl group" as used herein refers to a group derived from a thioether with R as an aryl group. The group has 6 to 60 carbon atoms. When the C₆-C₆₀ thioaryl group includes two or more rings, the rings may be fused to each other. The examples thereof include a thiophenyl group, a thionaphthyl group, a thioanthryl group, a thiophenanthryl group, a thiopyryl group, a thiobenzofuranyl group, a thioindolyl group, a thioquinolyl group, a thiopyridazinyl group, a thionaphthoquinolyl group, a thiopyrimidinyl group, a thiochromenyl group, a thioacridinyl group, a thiodibenzothiophenyl group, a thiotriphenylmethyl group and others, or their deuterated analogues thereof.

The term "C₄-C₆₀ heterothioaryl" as used herein refers to a thioaryl group having 4 to 60 carbon atoms, where two or more rings fused to each other, at least one heteroatom selected from N, O, Si, P, and S, other than carbon atoms, as a ring-forming atom. Examples of the thereof include a pyrimidothioaryl group, a thieno[2,3-b][1,4]dioxinyl group, a pyrazinothioaryl group, a benzothiazolyl group, a dibenzothiophenyl group, a thiopheno[3,4-b]pyrrolyl group, an isothiazolylthioaryl group, a naphthothiophenyl group, a thianthrenyl group, an indolizinothioaryl group, a dithiolo[3,4-b]pyrrolyl group, a selenopheno[2,3-b]pyridinyl group, a pyrrolo[2,3-b]thiophenyl group, an oxazolo[2,3-b]pyridinylthioaryl group, a pyrrolizinothioaryl group and others, or their deuterated analogues thereof.

The term "C₁-C₁₀ amino group" as used herein refers to an organic compound comprises -N(R)₂, where R is, together or independently, selected from: hydrogen, deuterium, alkyl, alkenyl, alkynyl, aryl group, and heteroarylo group. The amino group has 1 to 10 carbon atoms, or their deuterated analogues thereof.

The term "C₁-C₁₀ alkylamino" as used herein refers to an amino group wherein R is an alkyl group, or their deuterated analogues thereof.

The term "C₁-C₁₀dialkylamino" as used herein refers to an amino group wherein both Rs are alkyl groups, or their deuterated analogues thereof.

The term "C₆-C₆₀ arylamino group" as used herein refers to an amino group wherein R is an aryl group, or their deuterated analogues thereof.

The term "C₆-C₆₀ diarylamino group" as used herein refers to an amino group wherein both Rs are aryl groups, or their deuterated analogues thereof.

The term "C₆-C₆₀ heteroarylamino group" as used herein refers to an amino group wherein R is a heteroaryl group, or their deuterated analogues thereof.

The term "C₆-C₆₀ heterodiarylamino group" as used herein refers to an amino group wherein both Rs are heteroaryl groups. The examples of the amino group includes a methylamino group, a phenylamino group, a diphenylamino group, a naphthylamino group, a 9-methyl-anthracenylamino group, an ammonium group, a dimethylamino group, a diethylamino group, a methylanilino group, an ethylanilino group, an ethylphenylamino group, a diethylphenylamino group, a methoxymethylamino group, a methylbenzylamino group, an anilino group, a phenanthrylamino group, an ethoxyethylamino group, a pyridinylamino group, a quinolinylamino group, an isoquinolinylamino group, an imidazolylamino group, a benzimidazolylamino group, a triazolylamino group, a pyrazinylamino group, a pyrimidinylamino group, a thiazolylamino group, an oxazolylamino group, an isoxazolylamino group, an indolylamino group, a quinoxalinylamino group, a benzothiazolylamino group, a benzoxazolylamino group, a carbamoyl group, a thiocarbamoyl group, a sulfonylamino group, a sulfamoyl group, an amidoaryl group, a hydrazinyl group, a hydrazinoaryl group, a guanidinyl group, a guanidinoaryl group, an amidinyl group, an amidinoaryl group, a thiosemicarbazidyl group, a triazolethioamide group and others, or their deuterated analogues thereof.

The term "a cyano group" as used herein refers to a -C≡N functional group.

The term "a nitro group" as used herein refers to a -NO₂ functional group.

The term "a halogen" as used herein refers to fluorine, chlorine, bromine, or iodine.

The term "C₄-C₆₀ non-aromatic fused polycyclic group" as used herein refers to a group, having 4 to 60 carbon atoms, where two or more rings fused with each other, only carbon atoms as ring-forming atoms, and no aromaticity in its entire molecular structure. The examples thereof include a fluorenyl group, a cyclobutylcyclopentyl group, a cyclopentylcyclohexyl group, a decalinyl group, a bicyclo[3.2.1]octanyl group, a dicyclo[4.4.0]decanyl group, a spiro[4.4]nonanyl group, a tetracyclo[5.3.0.0²,⁶.0³,⁵]decanyl group, a pentacyclo[6.4.0.0²,⁶.0³,¹⁰.0⁵,⁹]dodecanyl group, a tricyclo[3.2.1.0²,⁴]octanyl group, a bicyclo[4.3.1]decanyl group, a tetradecahydrophenanthrenyl group, a tricyclo[5.3.1.0²,⁶]dodecanyl group, a dicyclo[6.4.0]tetradecanyl group, a pentacyclo[7.3.1.0²,⁷.0³,⁶]tetradecanyl group, a tetracyclo[8.3.1.0²,⁸.0³,¹⁰.0⁶,⁹]hexadecanyl group, a hexacyclo[9.3.1.0²,⁹.0³,¹¹.0⁶,¹⁰]octadecanyl group and others, or their deuterated analogues thereof.

The term "C₃-C₆₀ non-aromatic fused heteropolycyclic group" as used herein refers to a group, having 1 to 60 carbon atoms, where two or more rings fused to each other, at least one heteroatom selected from N, O, Si, P, and S, other than carbon atoms, as a ring-forming atom, and no aromaticity in its entire molecular structure. The examples thereof include an oxazolidinyl group, a silathiophenyl group, a pyrrolidinyl group, a phosphaseleninyl group, a dithiiranyl group, an oxathianyl group, a silaoxazinyl group, a thiaselenopyryl group, a phosphaoxazepinyl group, a pyrimidothiopyranyl group, a siladihydrothiazepinyl group, a pyrazinothiadiazinyl group, a phosphoazepinothiazinyl group, a triazolothiadiazinyl group, a sulfinylpyrazolopyridinyl group, an isoxazinothiopyranyl group, a thiadiazinylthiophenyl group, a dioxasilolanyl group, an oxatriazolothiopyridinyl group and others, or their deuterated analogues thereof.

### DETAILED DESCRIPTION OF THE INVENTION

The present invention is illustrated by the following examples in detail.

### Example 1. A boron-containing compound according to Formula I

Examples of inventive compounds are included in the compounds described according to Formula I and they do not limit the scope of protection of this application. The compound according to Formula I may be selected from: 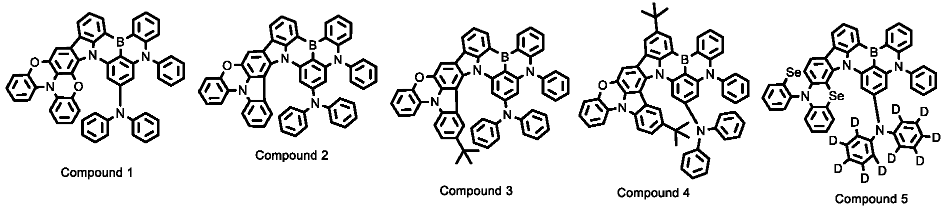 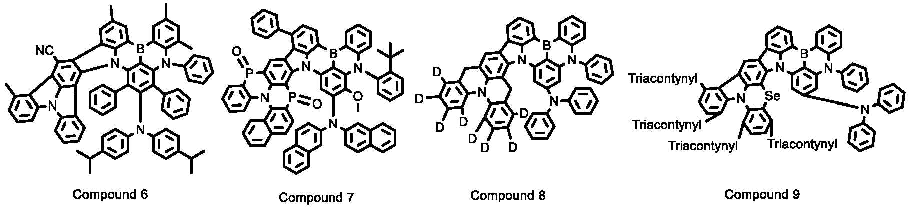 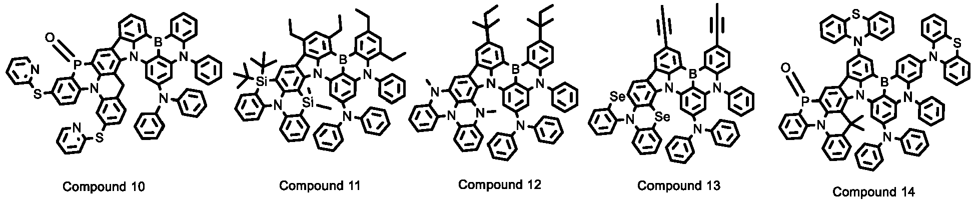 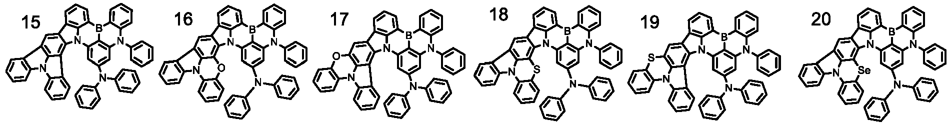 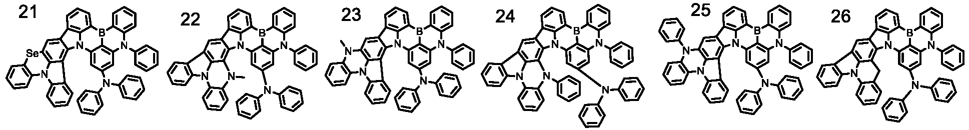 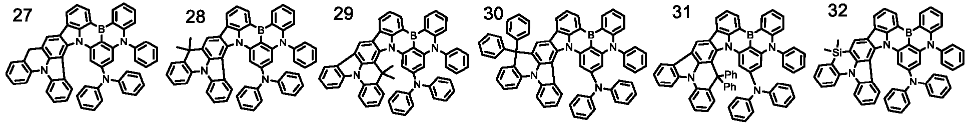 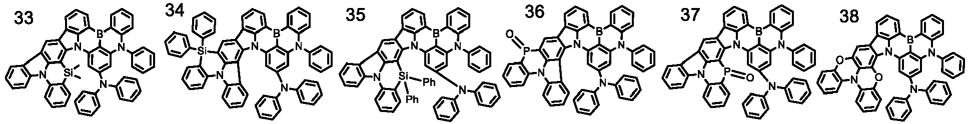 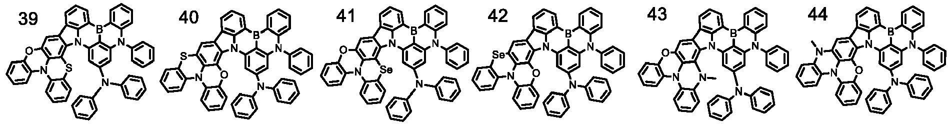 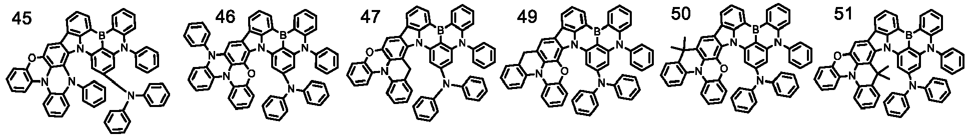 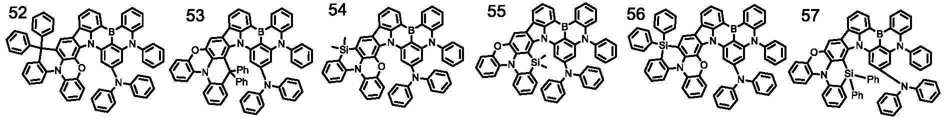 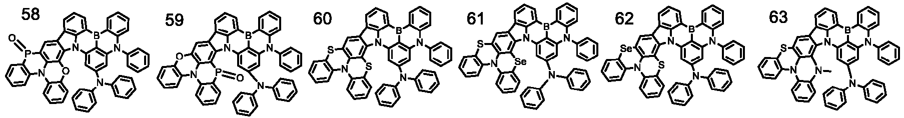 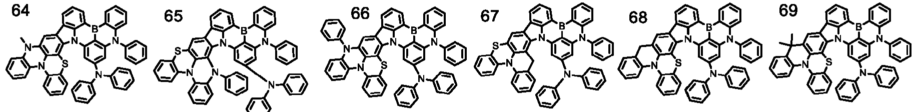 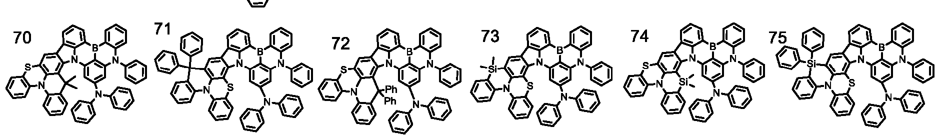 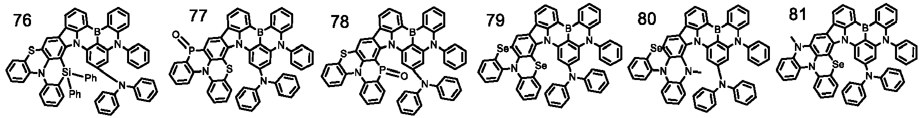 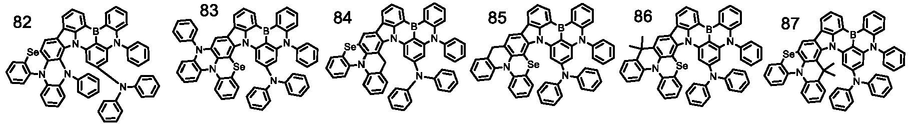 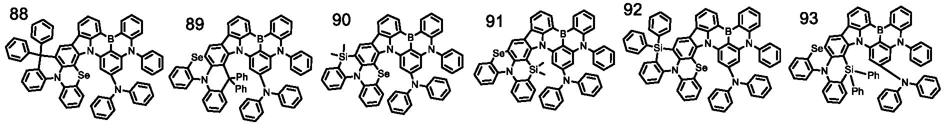 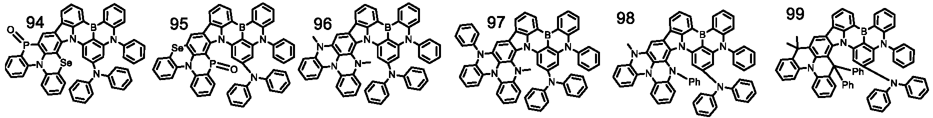 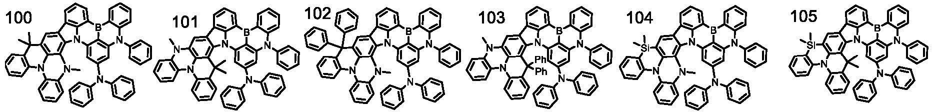 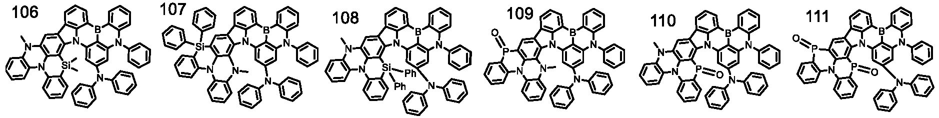 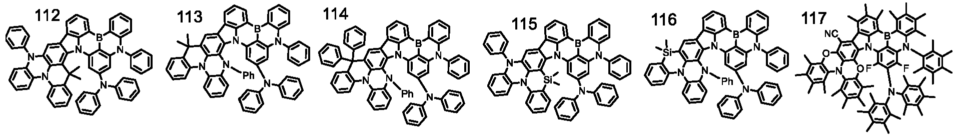 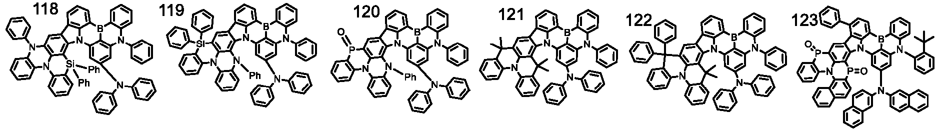 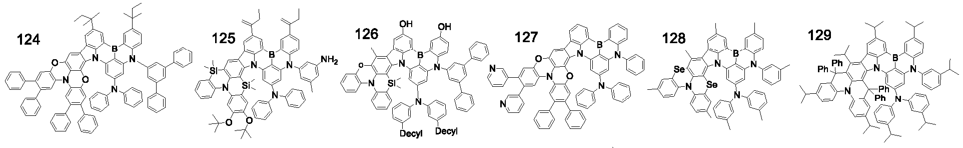 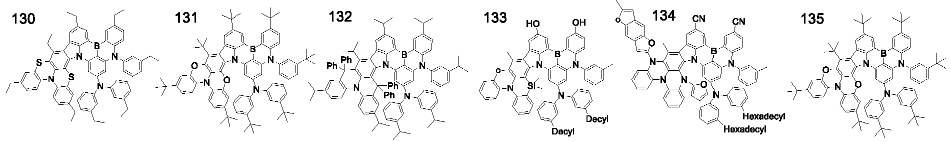 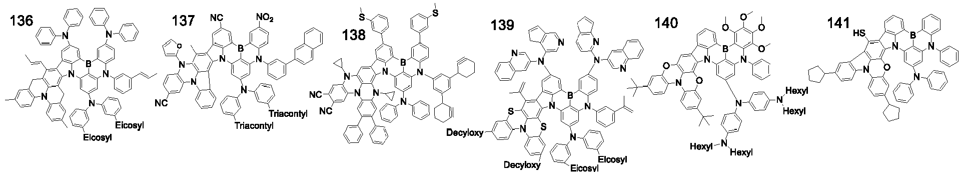 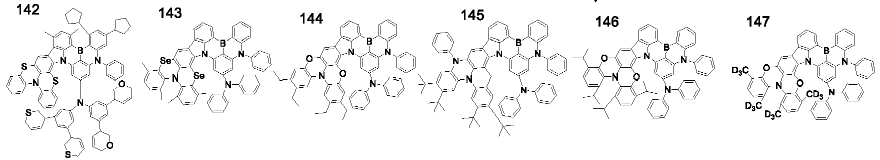 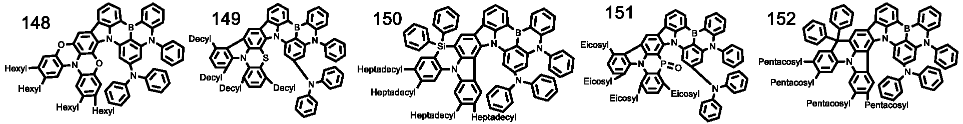 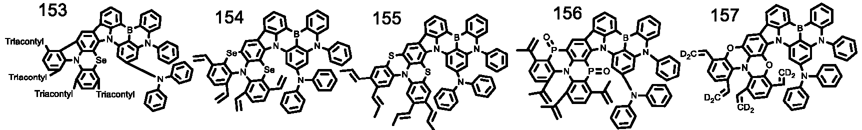 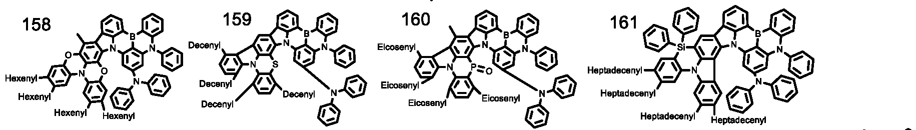 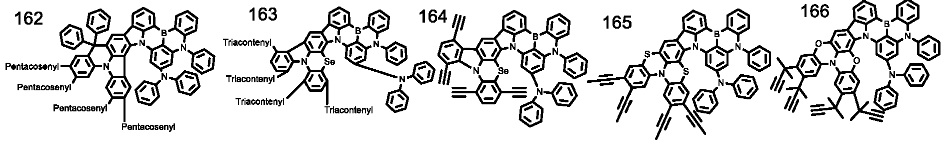 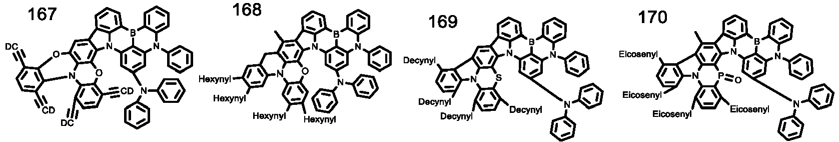 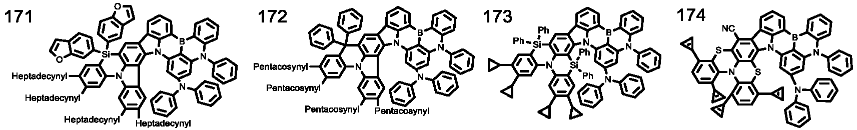 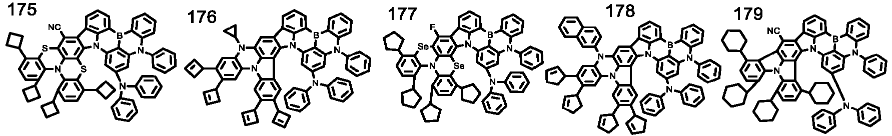 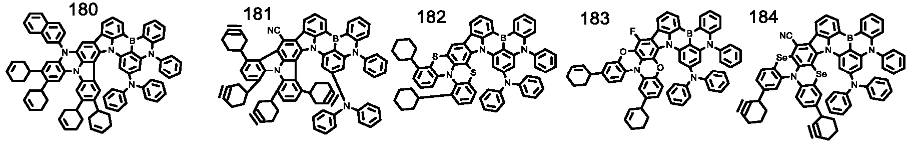 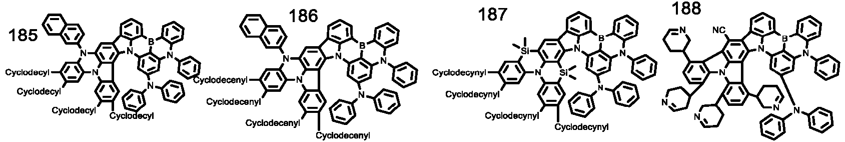 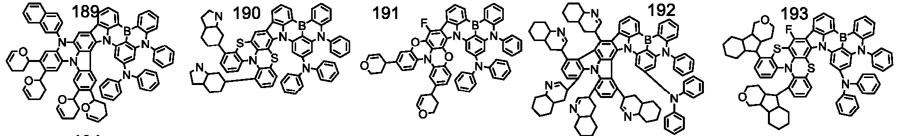 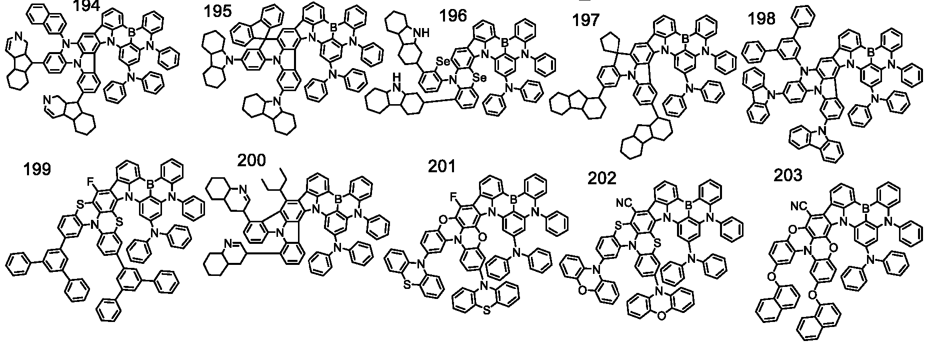 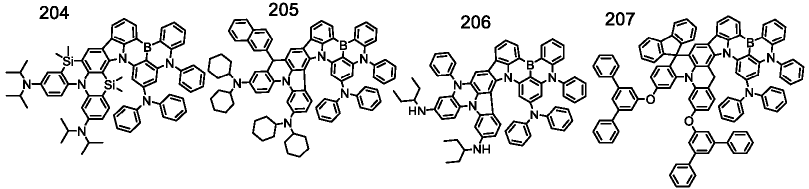 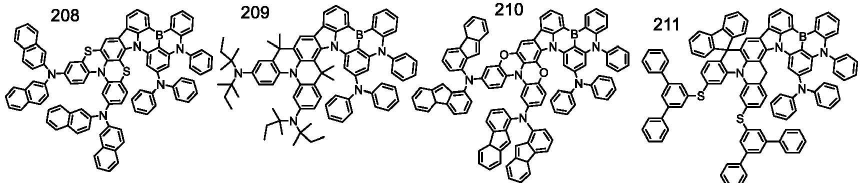 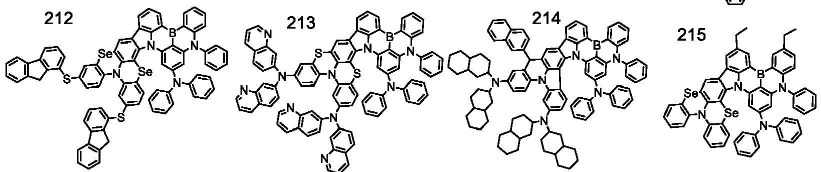 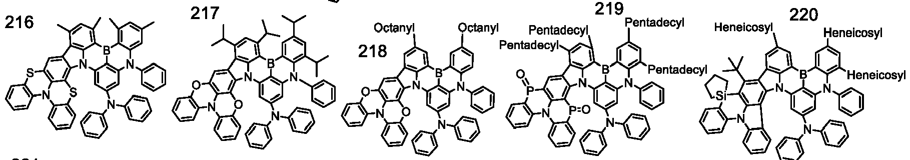 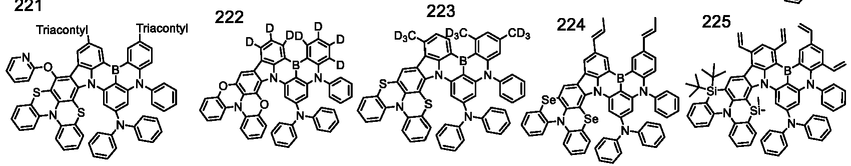 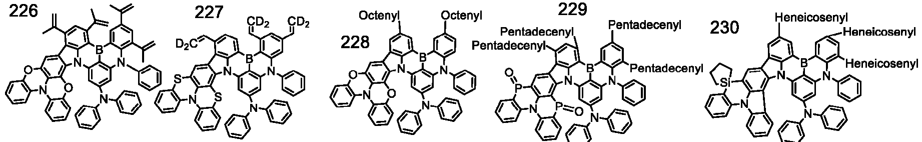 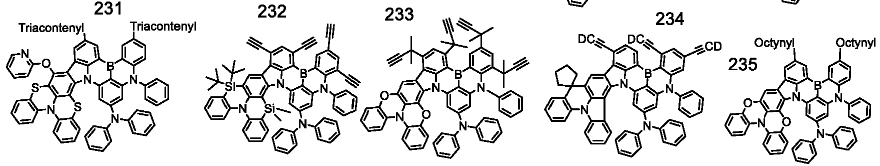 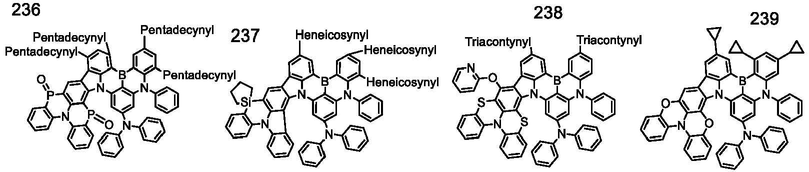 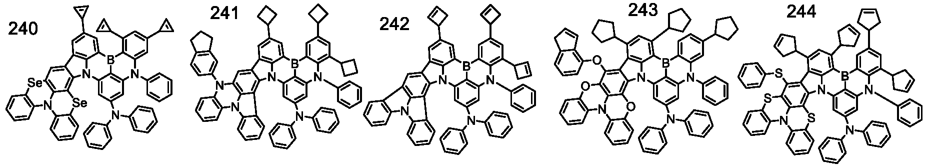 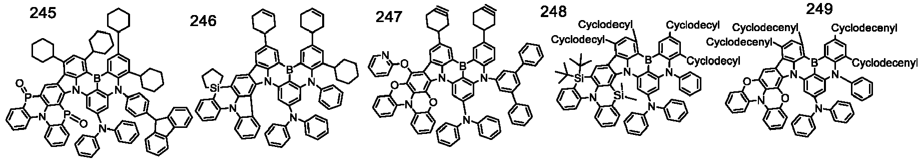 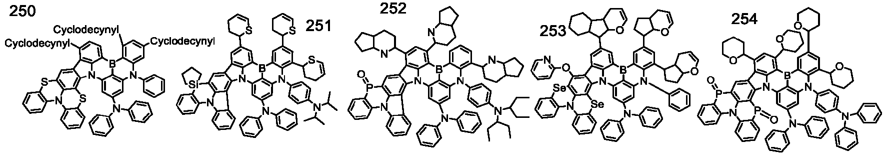 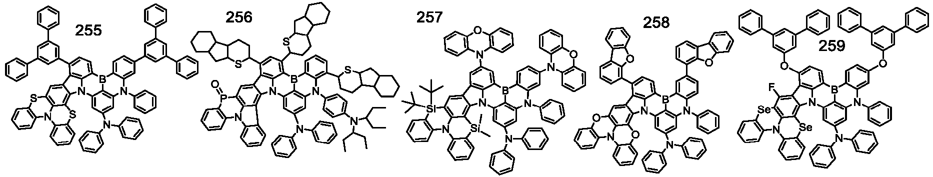 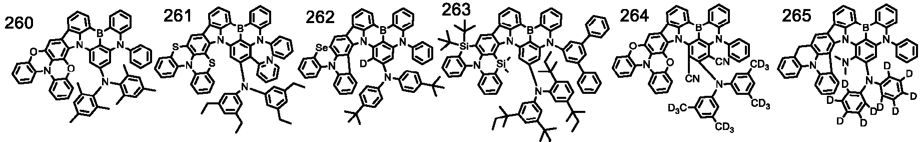 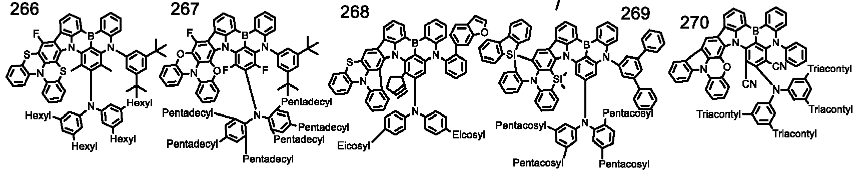 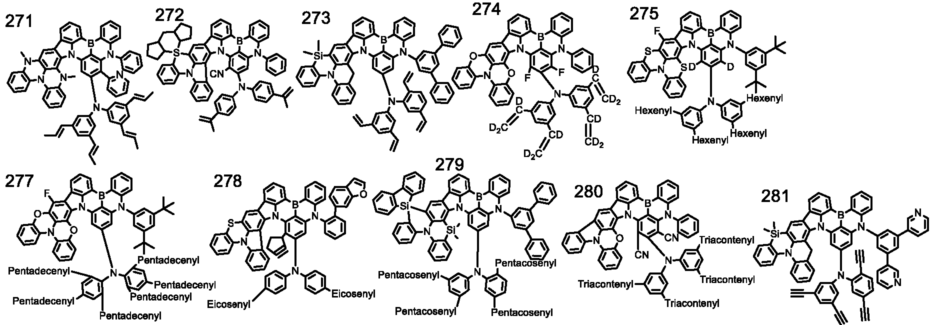 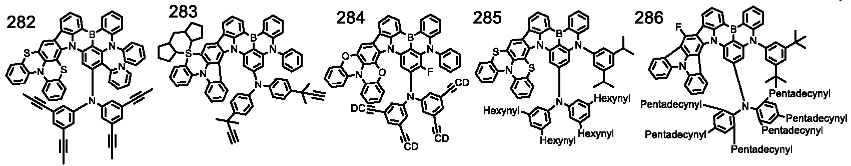 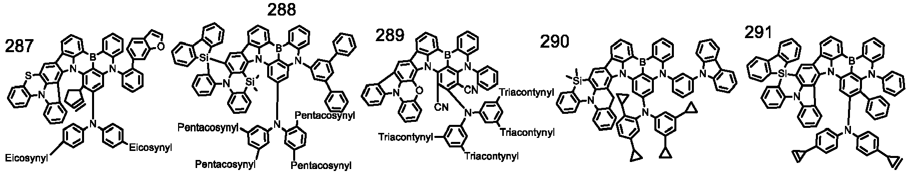 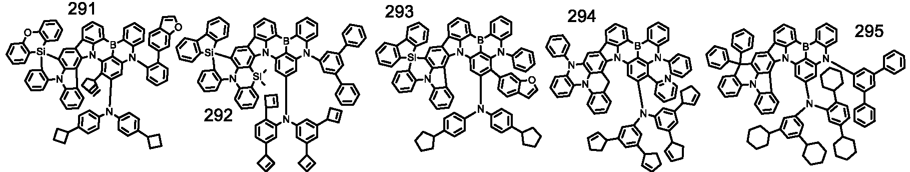 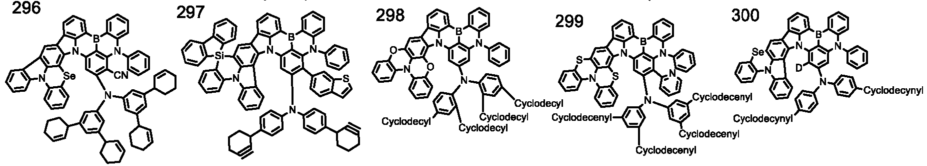 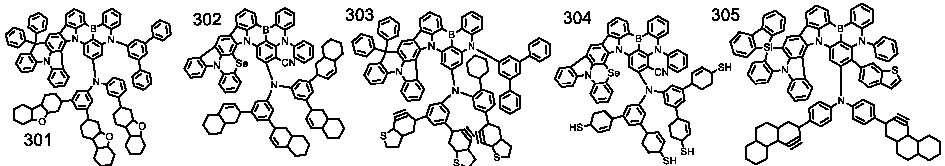 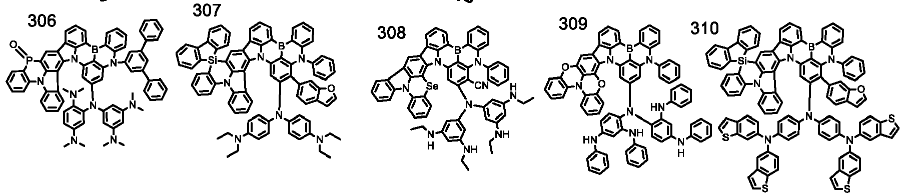 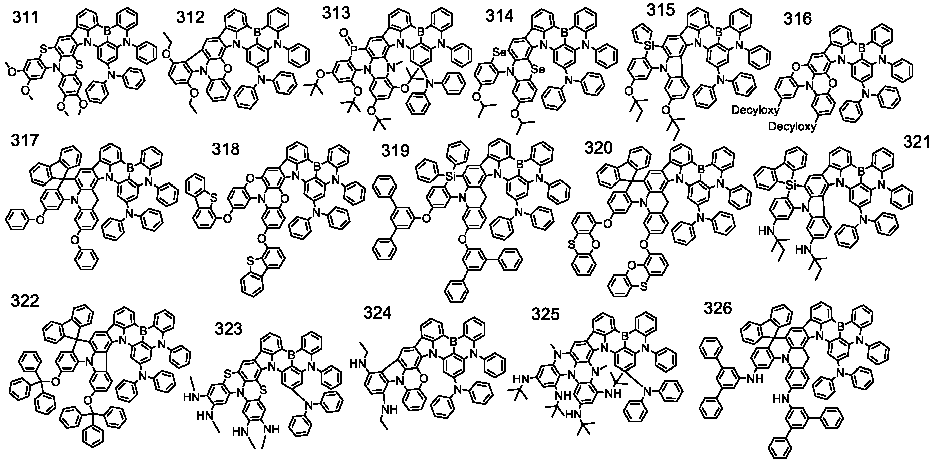 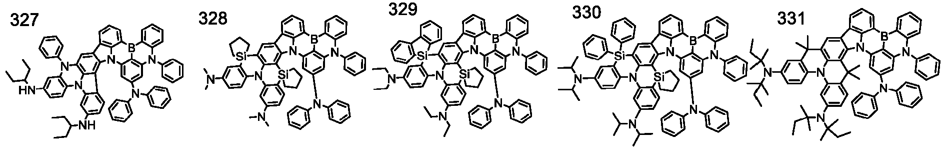 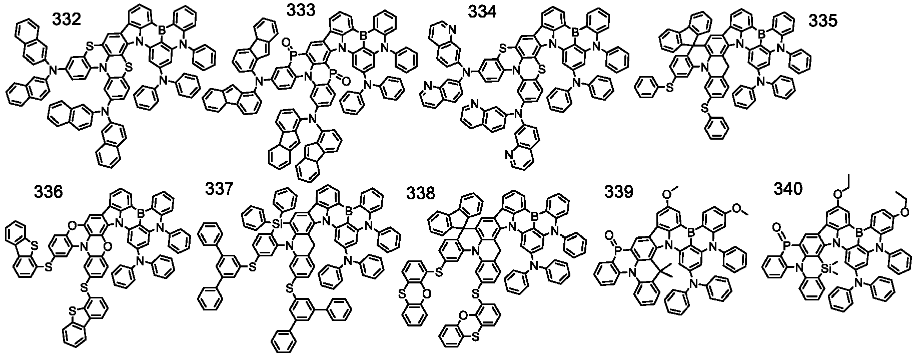 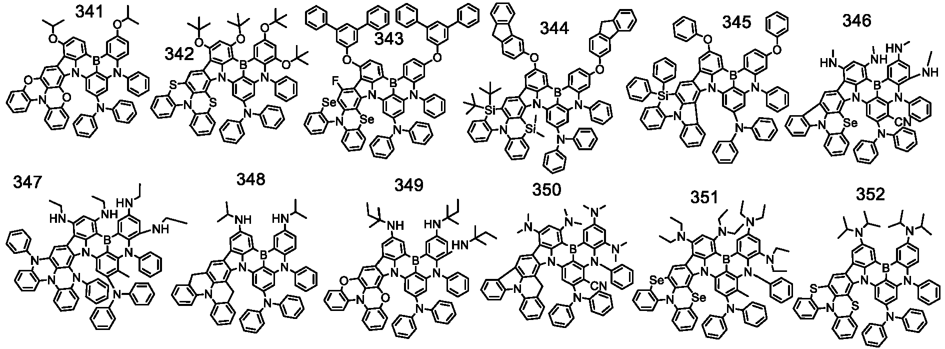 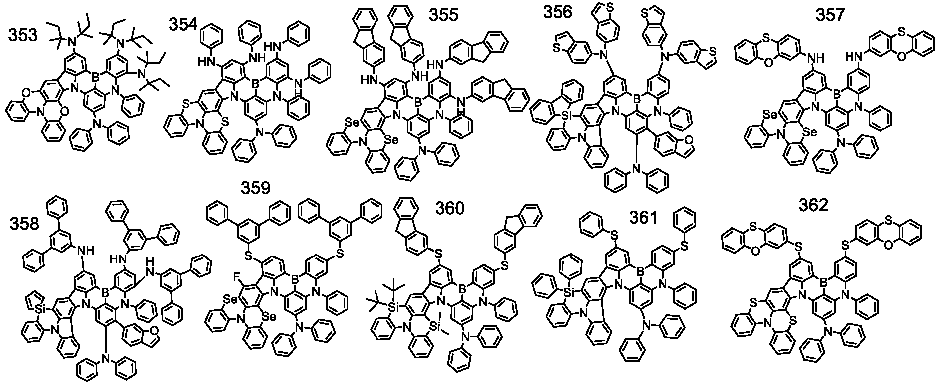 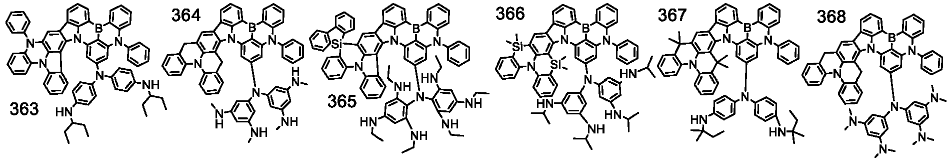 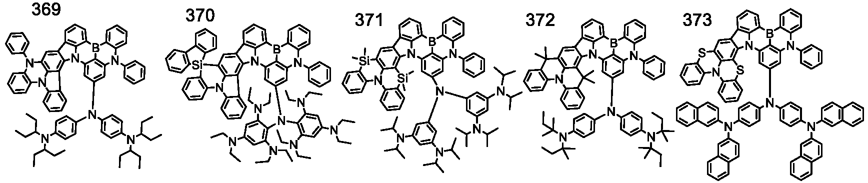 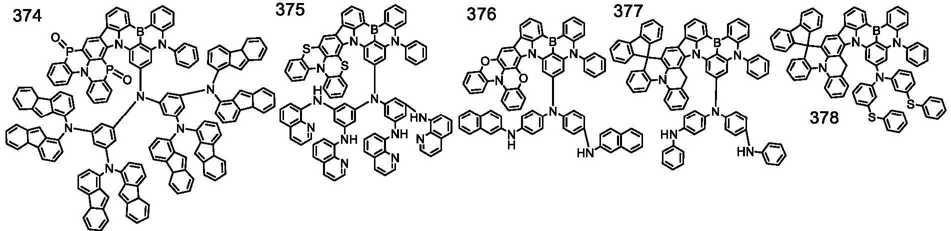 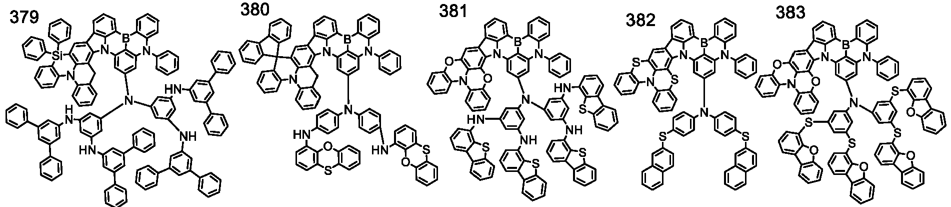 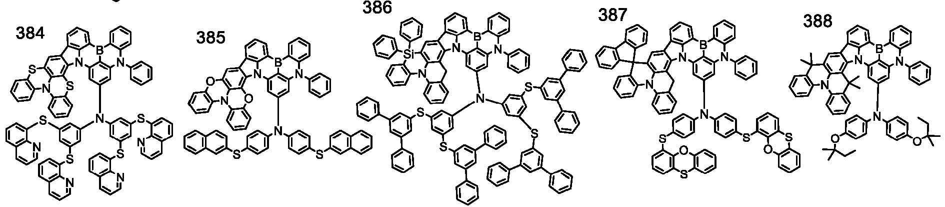 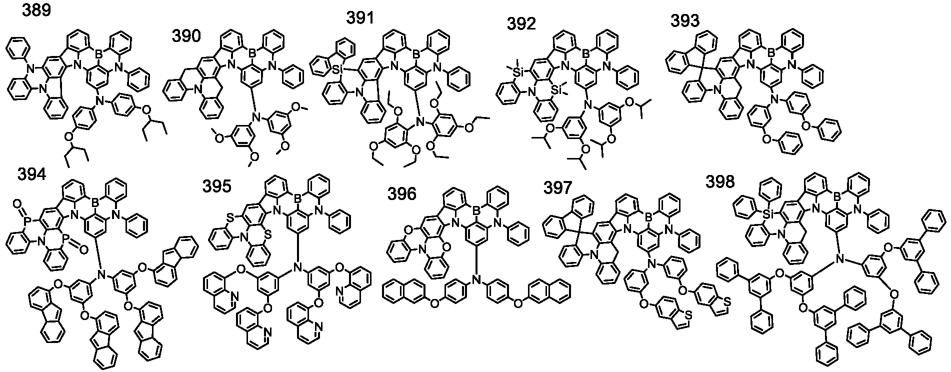 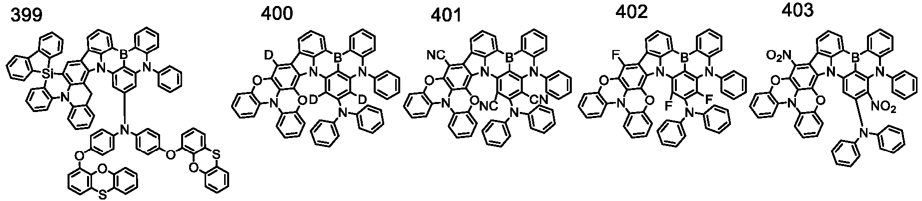 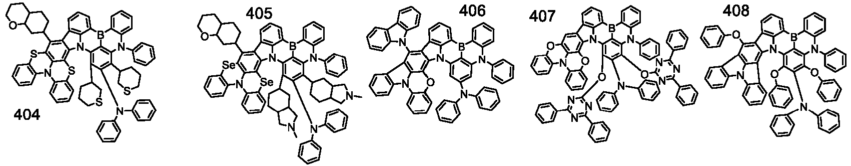 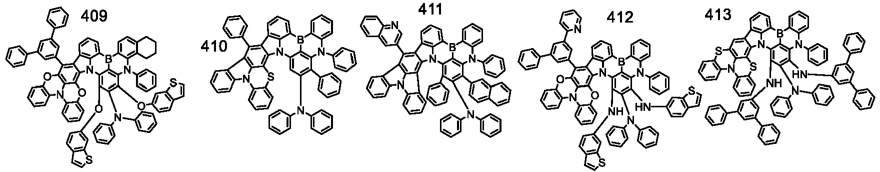 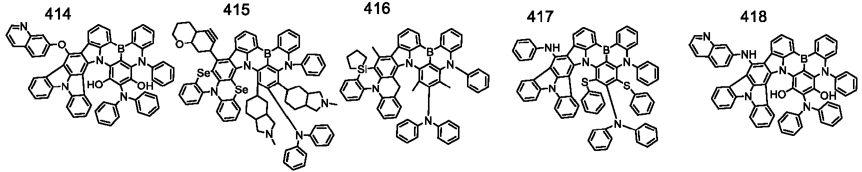 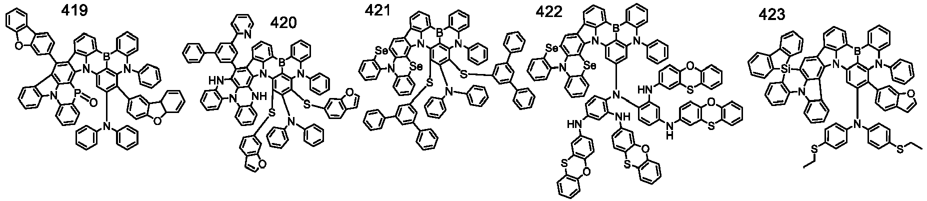 and deuterated analogues of thereof.

### Example 2: Process for obtaining compounds with the structure according to Formula I

The process of obtaining compounds with the structure represented by Formula I is presented in the following examples, which do not limit its scope of protection. The process of synthesizing the compounds of the embodiment will be exemplified through descriptions of processes for synthesizing **Compounds 1, 2, 3, 4.**

### 1.1. Synthesis of Compound 1 (Scheme 1) by a seven-step synthesis

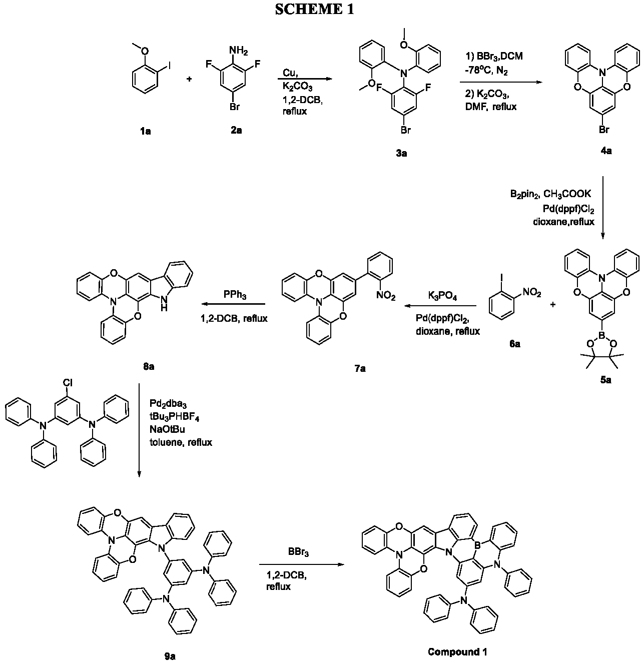

### a. Synthesis of 4-bromo-2,6-difluoro-N,N-bis(2-methoxyphenyl)aniline (3a)

To the solution of o-iodoanisole (**1a)** (5.85 g, 25.0 mmol, 2.5 eq.) and 4-bromo-2,6-difluoroaniline (**2a)** (2.08 g, 10.0 mmol, 1 eq.) in 40 ml of anhydrous o-dichlorobenzene, K₂CO₃ (6.9 g, 50 mmol, 5 eq.), copper powder (3.2 g, 50 mmol, 5 eq.) were added. The mixture was refluxed overnight. Then insoluble materials were filtered through celite and washed with dichloromethane. The combined filtrate was washed with water and extracted with dichloromethane. The organic phase was dried over MgSO₄, filtered off, and concentrated under reduced pressure. The obtained crude product was washed with hexane to give 3.4 g of light-yellow solid in 81% yield. ¹H NMR (400 MHz, CDCl₃): δ 7.08-7.04 (m, 2H), 7.03-6.97 (m, 2H) 6.92-6.83 (m, 6H), 3.60 (s, 6H)

### b. Synthesis of 7-bromobenzo[5,6][1,4]oxazino[2,3,4-kl]phenoxazine 4a

4-bromo-2,6-difluoro-N,N-bis(2-methoxyphenyl)aniline (**3a)** (3.0 g, 7.14 mmol, 1 eq.) was dissolved in dry dichloromethane. The solution was cooled to -78°C, then BBr₃ (2.0 ml, 20.8 mmol, 2 eq.) was added and the mixture was slowly warmed up to room temperature and stirred for 5 h. The reaction mixture was poured into water and extracted with dichloromethane. The organic phase was dried over MgSO₄, filtered off, and concentrated under reduced pressure to give 2.2 g (89% of yield) of crude product as a grey solid. The crude product was used for further reaction without purification. 2.2 g (5.6 mmol) of crude product was dissolved in 30 ml of DMF, potassium carbonate (2.76 g, 20 mmol) was added, and the mixture was refluxed overnight. After the addition of water, the product was extracted with dichloromethane. The organic phase was dried over MgSO₄, filtered off, and concentrated under reduced pressure to give 2.22 g of product in 89% yield as white solids. ¹H NMR (400 MHz, CDCl₃): δ 7.31-7.29 (m, 2H), 6.97-6.86 (m, 6H), 6.65 (s, 2H)

### c. Synthesis of 7-(4,4,5,5-tetramethyl-1,3,2-dioxaborolan-2-yl)benzo[5,6][1,4]oxazino[2,3,4-kl]phenoxazine (5a)

To the solution of 7-bromobenzo[5,6][1,4]oxazino[2,3,4-kl]phenoxazine (**4a)** (1.06 g, 3.0 mmol, 1.0 eq.) in 6 ml of 1,4-dioxane, bis(pinacolato)diboron (1.14 g, 4.5 mmol, 1.5 eq.), potassium acetate (0.59 g, 6.0 mmol, 2 eq.) and Pd(dppf)Cl₂ (0.025 g, 0.3 mmol, 10% mol). The reaction mixture was refluxed overnight. The mixture was extracted with dichloromethane. The organic phase was dried over MgSO₄, filtered off and concentrated under reduced pressure. The residue was purified by column chromatography using mixture of petroleum ether:dichloromethane (3:1) as eluent provided the 1.18 g in 98% yield. ¹H NMR (700 MHz, CDCl₃): δ 7.31 (dd, 2H, J=8.0, 1.4 Hz), 6.94 (s, 2H), 6.93-6.87 (m, 6H), 1.32 (s, 12H)

### d. Synthesis of 7-(2-nitrophenyl)benzo[5,6][1,4]oxazino[2,3,4-kl]phenoxazine (7a)

7-(4,4,5,5-tetramethyl-1,3,2-dioxaborolan-2-yl)benzo[5,6][1,4]oxazino[2,3,4-kl]phenoxazine **(5a)** (1.31 g, 3.54 mmol, 1 eq.), 1-iodo-2-nitrobenzene (6a) (0.97 g, 3.9 mmol, 1.1 eq.), Pd(dppf)Cl₂ (0.174 g, 0.212 mmol, 6 % mol) were dissolved in 5 ml of 1,4-dioxane. Then 3M K₃PO₄ (6 eq.) was added. The mixture was refluxed overnight under nitrogen. The resulting solution was saturated with water and extracted with dichloromethane. The combined organic phase was dried and concentrated in vacuo, and the target product was purified by column chromatography on silica gel with petroleum ether:dichloromethane 1:1 to afford orange crystals 0.80 g (57%). ¹H NMR (400 MHz, CDCl₃): δ 7.81 (dd, 1H, J=8.0, 1.2 Hz), 7.59 (td, 1H, J=7.5, 1.3 Hz) 7.46 (td, 1H, J=7.9, 1.4 Hz), 7.40 (dd, 1H, J=7.7, 1.3 Hz), 7.33 (d, 2H, J=7.7 Hz), 6.98-6.88 (m, 6H), 6.46 (s, 2H)

### e. Synthesis of 16H-benzo[5,6][1,4]oxazino[4,3,2-mn]indolo[2,3-b]phenoxazine (8a)

Triphenylphosphine (0.66 g, 2.5 mmol, 2.5 eq.) was added to the solution of **7a** (0.395 g, 1.0 mmol, 1 eq.) in 3 ml od o-dichlorobenzene under nitrogen. The mixture was refluxed overnight. The resulting solution was saturated with water and extracted with dichloromethane. The combined organic phase was dried and concentrated in vacuo, and crude product was purified by column chromatography on silica gel with petroleum ether:ethyl acetate 95:5 to afford light orange solid 0.295 g (81%). ¹H NMR (400 MHz, DMSO-d6): δ 11.39 (s, 1H), 7.98 (d, 1H, J =8.0 Hz) 7.45-7.42 (m, 4H), 7.33 (t, 1H, J=7.5 Hz), 7.13-7.00 (m, 7H)

### f. Synthesis of 5-(16H-benzo[5,6][1,4]oxazino[4,3,2-mn]indolo[2,3-b]phenoxazin-16-yl)-N1,N1,N3,N3-tetraphenylbenzene-1,3-diamine (9a)

**8a** (1.0 g, 2.76 mmol, 1 eq.), 5-chloro-N1,N1,N3,N3-tetraphenylbenzene-1,3-diamine (1.34 g, 3.0 mmol, 1.1 eq.), sodium tert-butoxide (1.06 g, 11.0 mmol, 4 eq.) tri-tert-butylphosphonium tetrafluoroborate (0.088 g, 0.3 mmol, 11% mol) and Pd₂dba₃ (0.126 g, 0.14 mmol, 5% mol) was dissolved in anhydrous toluene (10 ml) under nitrogen and refluxed overnight. The reaction was cooled to room temperature and extracted with dichloromethane, washed with brine, and dried over Na₂SO₄, and concentrated in-vacuo to afford the crude product. The crude product was purified via column chromatography petroleum ether: dichloromethane 1:1 to obtain a green solid of **9a** (1.8 g, 85% of yield). ¹H NMR (400 MHz, THF-d8) 7.86 (d, 1H, J=7.8 Hz), 7.44-7.41 (m, 2H), 7.28-7.24 (m, 1H), 7.26 (s, 1H), 7.22-7.15 (m, 17H), 7.13-7.09 (m, 1H), 7.03-6.90 (m, 11H), 6.77 (d, 2H, J=2.2 Hz)

### g. Synthesis of N,N,18-triphenyl-18H-9,22-dioxa-4b,18,21b-triaza-13b-boranaphtho[1,2,3-hi]naphtho[3',2',1':4,10]anthra[1,2-a]aceanthrylen-20-amine - Compound 1

**9a** (0.78 g, 1.0 mmol) was completely dissolved in 30 mL of 1,2 dichlorobenzene (1,2-DCB) at room temperature. Then, boron tribromide (0.8 mL, 8.46 mmol) was drop-wisely over the period of 10 minutes under an inert condition (argon). Then, the mixture kept stirring at 185°C for 16 hours. The reaction progress was monitored using thin layer chromatography technique. The reaction was terminated by adding methanol and concentrated under a reduced pressure. After the complete elimination of solvents from the crude mixture, dissolved completely in chloroform and filtered through a silica bed. After the evaporation of solvents, methanol was added in excess amount. Then, the formed precipitate was filtered and washed with methanol several times. The collected solid was dried in an oven for 6 hours and subjected to sublimation under a reduced pressure to obtain the target final emitter (0.5 g, 63.5% of yield). ¹H NMR (400 MHz, CDCl₃) 8.84 (d, 1H, *J*=7.8 Hz), 8.67 (d, 1H, *J*=7.6 Hz), 8.06 (d, 1H, *J*=7.6 Hz), 7.56 (t, 1H, *J*=7.4 Hz), 7.47-7.52 (m, 2H), 7.39-7.46 (m, 2H), 7.31-7.36 (m, 3H), 7.25-7.29 (m, 5H), 7.03-7.11 (m, 8H), 6.90-6.99 (m, 6H), 6.83 (t, 1H, *J*=7.6 Hz), 6.76 (d, 1H, *J=8.7* Hz), 5.92 (d, 1H, *J=1.7* Hz)

### 1.2. Synthesis of Compound 2 (Scheme 2) via six-step synthesis

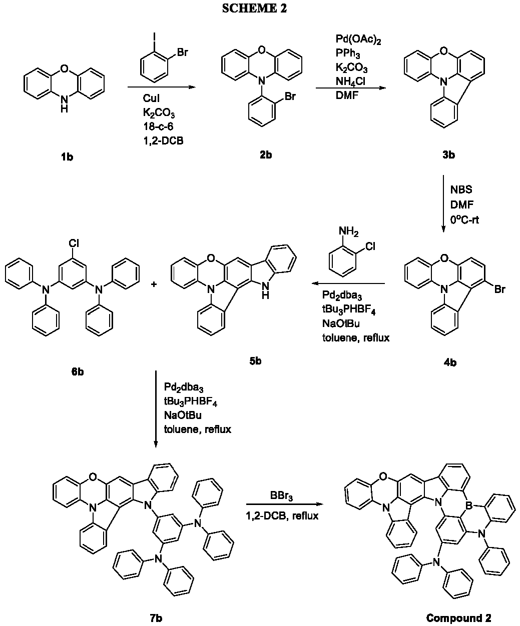

### a. Synthesis of 10-(2-bromophenyl)-10H-phenoxazine (2b)

Phenoxazine (**1b**) (1.00 g, 5.46 mmol, 1 eq.) was dissolved in 20 ml of 1,2-dichlorobenzene under nitrogen atmosphere, then 1-bromo-2-iodobenzene (1.70 g, 6 mmol, 1.1 eq.), CuI (4.16 g, 21.8 mmol, 4 eq.), 18 crown 6 ether (0.1 g, 0.38 mmol, 7% mol) and K₂CO₃ (6.0 g, 43.7 mmol, 8 eq.) were added. The mixture was refluxed overnight. The reaction solution was cooled to room temperature and filtered through celite. Afterwards, the mixture was transferred to a separation funnel, and extracted with dichloromethane, and washed with brine. The organic layer was dried over Na₂SO₄. The solvent was evaporated under reduced pressure. The crude material was purified by column chromatography on silica gel using the mixture of petroleum ether: dichloromethane 9:1 affording derivative **2b** as a white solid (1.25 g, 68%). ¹H NMR (400 MHz, CDCl₃) 7.83 (dd, 1H, J=8.0, 1.4 Hz), 7.53 (td, 1H, J=7.6, 1.4 Hz), 7.43 (dd, 1H, J=7.9, 1.7 Hz), 7.38-7.34 (m, 1H), 6.72-6.58 (m, 6H), 5.79 (dd, 2H, J=7.6, 1.2 Hz)

### b. Synthesis of indolo[3,2,1-kl]phenoxazine (3b)

10-(2-bromophenyl)-10H-phenoxazine **(2b)** (1.00 g, 2.96 mmol, 1 eq.) was dissolved in 10 ml of anhydrous DMF and K₂CO₃ (1.64 g, 11.84 mmol, 4 eq.), NH₄Cl (0.32 g, 5.92 mmol, 2 eq.), triphenylphosphine (19 mg, 0.07 mmol, 2.5% mol), palladium(II) acetate (16 mg, 0.07 mmol, 2.5% mol) were added under an argon atmosphere. The reaction mixture was refluxed and stirred overnight. The cooled reaction mixture was extracted with dichloromethane and washed with brine. The organic phase was dried over Na₂SO₄ and the solvent was removed under reduced pressure. The crude material was purified by column chromatography on silica gel using the mixture of petroleum ether:dichloromethane 3:1 affording derivative **3b** as a light yellow solid (715 g, 94%). ¹H NMR (400 MHz, CDCl₃) 8.04-8.02 (m, 1H), 7.53 (dt, 1H, J=8.4, 1.0 Hz), 7.66 (dd, 1H, J=7.9, 0.8 Hz), 7.54-7.50 (m, 1H), 7.44 (dd, 1H, J=7.9, 0.8 Hz), 7.32-7.28 (m, 1H), 7.06-6.93 (m, 4H), 6.71 (dd, 1H, J=7.7, 0.8 Hz)

### c. Synthesis of 5-bromoindolo[3,2,1-kl]phenoxazine (4b)

To the solution of **(3b)** (0.70 g, 2.72 mmol, 1 eq.) in 15 ml of anhydrous DMF in 0°C under nitrogen atmosphere, NBS (0.48 g, 2.72 mmol, 1 eq.) was added in small portions. The mixture was stirred overnight at room temperature. Then the reaction mixture was extracted with dichloromethane, washed with brine, dried over Na₂SO₄ and the solvent was removed under reduced pressure. The residue was purified by column chromatography using petroleum ether to obtain **4b** (0.9 g, yield 98%). ¹H NMR (400 MHz, CDCl₃) 8.68-8.65 (m, 1H), 7.89 (dt, 1H, J=8.5, 0.9 Hz), 7.68 (dt, 1H, J=8.2, 1.0 Hz), 7.59-7.54 (m, 1H), 7.45 (d, 1H, J=8 Hz), 7.38-7.34 (m, 1H), 7.06-7.03 (m, 1H), 6.98-6.97 (m, 2H), 6.59 (d, 1H, J= 8.3 Hz)

### d. Synthesis of 16H-diindolo[2,3-b:1',2',3'-mn]phenoxazine (5b)

**4b** (0.50 g, 1.49 mmol, 1 eq.), 2-chloroaniline (0.23 g, 1.78 mmol, 1.2 eq.), sodium *tert*-butoxide (0.430 g, 4.5 mmol, 3 eq.), tri-*tert*-butylphosphonium tetrafluoroborate (86 mg, 0.3 mmol, 21% mol) and Pd₂dba₃ (136 mg, 0.15 mmol, 10% mol) was dissolved in anhydrous toluene (4 ml) and refluxed under nitrogen overnight. The reaction was cooled to room temperature and extracted with dichloromethane, washed with brine, and dried over Na₂SO₄, and concentrated in-vacuo to afford the crude product. The crude product was purified via column chromatography using the mixture of petroleum ether: dichloromethane 3:1 to obtain a green solid (0.2 g, 39% of yield). ¹H NMR (700 MHz, DMSO-d6) 11.83 (s, 1H), 8.69 (d, 1H, J=7.7 Hz), 8.25 (d, 1H, J=8.4 Hz), 8.07 (d, 1H, J=7.7 Hz), 8.00 (dd, 1H, J=8.0, 1.3), 7.62 (s, 1H), 7.60-7.58 (m, 2H) 7.47 (t, 1H, J=7.3 Hz), 7.34 (t, 1H, J=7.5 Hz), 7.17 (t, 1H, J=7.5 Hz) 7.14-7.06 (m, 3H)

### e. Synthesis of 5-(16H-diindolo[2,3-b:1',2',3'-mn]phenoxazin-16-yl)-N1,N1,N3,N3-tetraphenylbenzene-1,3-diamine (7b)

**5b** (102 mg, 0.29 mmol, 1 eq.), 5-chloro-N1,N1,N3,N3-tetraphenylbenzene-1,3-diamine (**6b)** (145 mg, 0.32 mmol, 1.1 eq.), sodium *tert*-butoxide (111 mg, 1.16 mmol, 4 eq.) tri-*tert*-butylphosphonium tetrafluoroborate (9 mg, 0.03 mmol, 11% mol) and Pd₂dba₃ (13 mg, 0.015 mmol, 5% mol) was dissolved in anhydrous toluene (4 ml) under nitrogen and refluxed overnight. The reaction was cooled to room temperature and extracted with dichloromethane, washed with brine, and dried over Na₂SO₄ and concentrated in-vacuo to afford the crude product. The crude product was purified via column chromatography using the mixture of petroleum ether:dichloromethane 3:1 to obtain a green solid of **7b** (210 mg, 94% of yield). ¹H NMR (400 MHz, THF-d8 ) 8.18 (d, 1H, J=8.5 Hz), 7.96-7.90 (m, 2H), 7.61-7.57 (m, 1H), 7.43 (s, 1H), 7.38-7.34 (m, 1H), 7.32-7.24 (m, 2H), 7.17-7.04 (m, 18H), 7.01-6.98 (m, 3H), 6.95 (d, 1H, J=8.1 Hz), 6.90 (t, 1H, J=1.5 Hz), 6.89-6.88 (m, 2H), 6.88-6.87 (t, 1H, J=1.7 Hz), 6.73 (d, 2H, J=2 Hz)

### f. Synthesis of - N,N,18-triphenyl-18H-9-oxa-4b,18,21b-triaza-13b-borabenzo[1,2]aceanthryleno[3,4-a]naphtho[1,2,3-hi]aceanthrylen-20-amine Compound 2

**7b** (1.17 g, 1.53 mmol) was completely dissolved in 20 mL of 1,2 dichlorobenzene (1,2-DCB) at room temperature. Then, boron tribromide (1.0 mL, 10.56 mmol) was drop-wisely over the period of 12 minutes under an inert condition (argon ). Then, the mixture kept stirring at 180°C for 18 hours. The reaction progress was monitored by using thin layer chromatography technique. The reaction was terminated by adding methanol and concentrated under a reduced pressure. After complete elimination of solvents from the crude mixture, dissolved completely in ethyl acetate and filtered through a silica bed. After the evaporation of solvents, methanol was added in excess amount. Then, the formed precipitate was filtered and washed with methanol and petroleum ether several times. The collected solid was dried in an oven for 4 hours and subjected to sublimation under a reduced pressure to obtain the target final emitter (0.63 g, 53.9% of yield). ¹H NMR (400 MHz, THF-d8) 8.87 (d, 1H, *J*=7.7 Hz), 8.66 (d, 1H, *J*=7.5 Hz), 8.22 (d, 1H, *J*=7.6 Hz), 8.13 (d, 1H, *J=8.7* Hz), 7.94 (d, 1H, *J*=7.9 Hz), 7.72 (d, 1H, *J=8.2* Hz), 7.40-7.62 (m, 8H), 7.23-7.32 (m, 3H), 7.00-7.12 (m, 3H), 6.92-6.97 (m, 4H), 6.77-6.86 (m, 7H), 6.61 (d, 1H, *J=1.8* Hz), 6.10 (d, 1H, *J=7.8* Hz)

### 1.3. Synthesis of Compound 3 (Scheme 3) via six-step synthesis

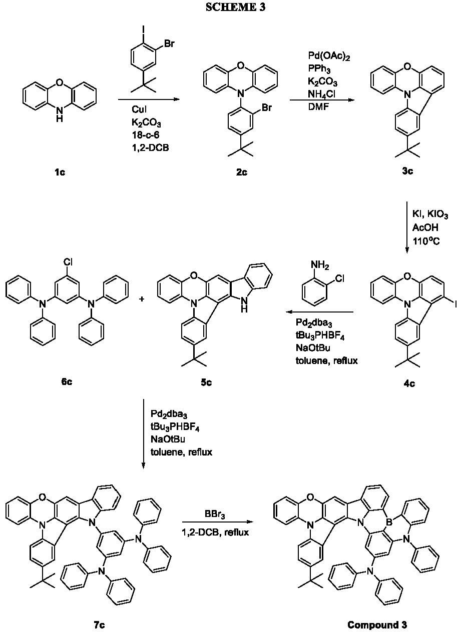

### a. Synthesis of 10-(2-bromo-4-(tert-butyl)phenyl)-10H-phenoxazine (2c)

Phenoxazine **1c** (183 mg, 1 mmol, 1 eq.) was dissolved in 20 ml of 1,2-dichlorobenzene under nitrogen atmosphere, then 2-bromo-4-(*tert*-butyl)-1-iodobenzene (407 mg, 1.2 mmol, 1.1 eq.), CuI (762 mg, 4 mmol, 4 eq.), 18 crown 6 ether (20 mg, 7% mol) and K₂CO₃ (1.1 g, 8 mmol, 8 eq.) were added. The mixture was refluxed overnight. The reaction solution was cooled to room temperature and filtered through celite. Afterwards, the mixture was transferred to a separation funnel and extracted with dichloromethane and washed with brine. The organic layer was dried over Na₂SO₄. The solvent was evaporated under reduced pressure. The crude material was purified by column chromatography on silica gel using the mixture of petroleum ether: dichloromethane 3:1 affording derivative **2c** as a white solid (221 mg, 56%). ¹H NMR (400 MHz, CDCl₃) 7.83 (dd, 1H, J=2.2 Hz), 7.53 (dd, 1H, J=8.4, 2.3 Hz), 7.35 (d, 1H, J=8.3 Hz), 6.74-6.61 (m, 6H), 5.79 (d, 2H, J=7.8 Hz), 1.41 (s, 9H)

### b. Synthesis of 10-(tert-butyl)indolo[3,2,1-kl]phenoxazine (3c)

10-(2-bromo-4-(*tert*-butyl)phenyl)-10H-phenoxazine **2c** (1.00 g, 2.5 mmol, 1 eq.) was dissolved in 10 ml of anhydrous DMF and K₂CO₃ (1.4 g, 10.1 mmol, 4 eq.), NH₄Cl (0.27 g, 5.0 mmol, 2 eq.), triphenylphosphine (17 mg, 0.06 mmol, 2.5% mol), palladium(II) acetate (14 mg, 0.06 mmol, 2.5% mol) were added under an argon atmosphere. The reaction mixture was refluxed and stirred overnight. The cooled reaction mixture was extracted with dichloromethane and washed with brine. The organic phase was dried over Na₂SO₄ and the solvent was removed under reduced pressure. The crude material was purified by column chromatography on silica gel using petroleum ether affording derivative **3c** as a white solid (743 g, 94%). ¹H NMR (400 MHz, CDCl₃) 8.04-8.02 (d, 1H, J=1.9 Hz), 7.80 (d, 1H, J=8.7 Hz), 7.62 (dd, 1H, J=8.0, 1.4 Hz), 7.58 (dd, 1H, J=8.8, 2.1 Hz), 7.44 (d, 1H, J=8.1 Hz), 7.04-6.90 (m, 4H), 6.68 (dd, 1H, J=7.7, 0.6 Hz), 1.45 (s, 9H)

### c. Synthesis of 10-(tert-butyl)-8-iodoindolo[3,2,1-kl]phenoxazine (4c)

To the solution of **3c** (313 mg, 1 mmol, 1 eq.) in 3 ml of glacial acetic acid potassium iodide (139 mg, 0.9 mg, 0.9 mmol, 0.9 eq.) was added and stirred at 110°C/1h. Potassium iodate (107 mg, 0.5 mmol, 0.5 eq.) was added and the mixture was stirred 1h at 100°C. Then the reaction mixture was extracted with dichloromethane, washed with brine, dried over Na₂SO₄ and the solvent was removed under reduced pressure. The residue was purified by column chromatography using petroleum ether to obtain **4c** (395 mg, yield 90%). NMR spectrum confirmed the structure of compound **4c.**

### d. Synthesis of 2-(tert-butyl)-16H-diindolo[2,3-b:1',2',3'-mn]phenoxazine (5c)

**4c** (0.787 g, 1.8 mmol, 1 eq.), 2-chloroaniline (0.343 g, 2.69 mmol, 1.5 eq.), sodium *tert*-butoxide (0.344 g, 3.6 mmol, 3 eq.), tri-*tert*-butylphosphonium tetrafluoroborate (109 mg, 0.38 mmol, 21% mol) and Pd₂dba₃ (136 mg, 0.15 mmol, 10% mol) was dissolved in anhydrous toluene (4 ml) and refluxed under nitrogen overnight. The reaction was cooled to room temperature and extracted with dichloromethane, washed with brine and dried over Na₂SO₄ and concentrated in-vacuo to afford the crude product. The crude product was purified via column chromatography using the mixture of petroleum ether to obtain a green solid (0.70 g, 40% of yield). ¹H NMR (400 MHz, THF-d8) 10.83 (s, 1H), 8.50 (d, 1H, J=1.9 Hz), 8.01 (d, 1H, J=9.1 Hz), 7.95 (d, 1H, J=7.9. Hz), 7.85 (dd, 1H, J=7.9, 1.4 Hz), 7.61 (dd, 1H, J=8.9, 2.1 Hz), 7.45 (d, 1H, J=7.8 Hz), 7.41 (s, 1H), 7.26 (t, 1H, J=7.7 Hz), 7.12 (t, 1H, J=7.7 Hz), 7.06-6.93 (m, 3H), 1.51 (s, 1H)

### e. Synthesis of 5-(2-(tert-butyl)-16H-diindolo[2,3-b:1',2',3'-mn]phenoxazin-16-yl)-N1,N1,N3,N3-tetraphenylbenzene-1,3-diamine (7c)

**5c** (116 mg, 0.29 mmol, 1 eq.), 5-chloro-N1,N1,N3,N3-tetraphenylbenzene-1,3-diamine 6 (145 mg, 0.32 mmol, 1.1 eq.), sodium *tert*-butoxide (111 mg, 1.16 mmol, 4 eq.) tri-*tert*-butylphosphonium tetrafluoroborate (9 mg, 0.03 mmol, 11% mol) and Pd₂dba₃ (13 mg, 0.015 mmol, 5% mol) was dissolved in anhydrous toluene (4 ml) under nitrogen and refluxed overnight. The reaction was cooled to room temperature and extracted with dichloromethane, washed with brine and dried over Na₂SO₄ and concentrated in-vacuo to afford the crude product. The crude product was purified via column chromatography using mixture of petroleum ether: dichloromethane 4:1 to obtain a green solid of **7c** (236 mg, 94% of yield). ¹H NMR (400 MHz, THF-d8 ) 8.15 (d, 1H, J=8.3 Hz), 7.90-7.95 (m, 2H), 7.65 (d, 1H, J=7.9), 7.43 (s, 1H), 7.42-7.38 (m, 1H), 7.33 (s, 1H), 7.17-7.04 (m, 18H), 7.00-6.95 (m, 3H), 6.95 (d, 1H, J=7.9 Hz), 6.86 (t, 1H, J=1.3 Hz), 6.84-6.82 (m, 2H), 6.70-6.68 (t, 1H, J=1.7 Hz), 6.56 (d, 2H, J=2.3 Hz), 1.49 (s, 9H)

### f. Synthesis of 2-(tert-butyl)-N,N,18-triphenyl-18H-9-oxa-4b,18,21b-triaza-13b-borabenzo[1,2]aceanthryleno[3,4-a]naphtho[1,2,3-hi]aceanthrylen-20-amine (Compound 3)

**7c** (1.3 g, 1 eq.) was completely dissolved in 10 mL of 1,2 dichlorobenzene (1,2-DCB) at room temperature. Then, boron tribromide (1.0 mL, 3 eq.) was dropped-wisely over the period of 5 minutes under an inert condition (CO₂). Then, the mixture kept stirring at 180°C for 16 hours. The reaction progress was monitored by using thin layer chromatography technique. The reaction was terminated by adding methanol and concentrated under a reduced pressure. After complete elimination of solvents from the crude mixture, dissolved completely in dichloromethane and filtered through a silica bed. After the evaporation of solvents, methanol was added in excess amount. Then, formed precipitate was filtered and washed with methanol and petroleum ether several times. The collected solid was dried in an oven for 7 hours and subjected to sublimation under a reduced pressure to obtain the target final emitter (50% of yield). The structure was confirmed by mass (LC) and NMR spectrum.

### 1.4. Synthesis of Compound 4 (Scheme 4) via six-step synthesis.

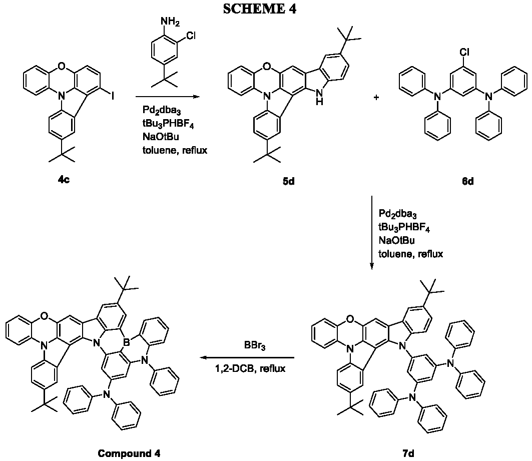

### a. Synthesis of 10-(tert-butyl)-8-iodoindolo[3,2,1-kl]phenoxazine (4c)

Compound **4c** was synthesized according to the procedure for compound **4c** presented in Synthesis **1.3.**

### b. Synthesis of 2,13-di-tert-butyl-16H-diindolo[2,3-b:1',2',3'-mn]phenoxazine (5d)

**4c** (397 mg, 0.9 mmol, 0.9 eq.), 2-chloro-4-(*tert*-butyl)aniline (227 mg, 0.99 mmol, 0.99 eq.), sodium tert-butoxide (347 mg, 3.6 mmol, 4 eq.), tri-*tert*-butylphosphonium tetrafluoroborate (55 mg, 0.19 mmol, 21% mol) and Pd₂dba₃ (83 mg, 0.9 mmol, 10% mol) was dissolved in anhydrous toluene (4 ml) and refluxed under nitrogen overnight. The reaction was cooled to room temperature and extracted with dichloromethane, washed with brine, and dried over Na₂SO₄ and concentrated in-vacuo to afford the crude product. The crude product was purified via column chromatography using the mixture of petroleum ether: dichloromethane 4:1 to obtain a green solid (186 mg, 45 % of yield). ¹H NMR (400 MHz, THF-d8) 10.63 (s, 1H), 8.47 (d, 1H, J=1.9 Hz), 8.01-7.99 (m, 2H), 7.85 (dd, 1H, J=7.9, 1.5 Hz), 7.60 (dd, 1H, J=9.0, 2.0 Hz), 7.44 (s, 1H), 7.39-7.34 (m, 2H) 7.05-6.93 (m, 3H), 1.51 (s, 9H), 1.44 (s, 9H)

### c. Synthesis of 5-(2,13-di-tert-butyl-16H-diindolo[2,3-b:1',2',3'-mn]phenoxazin-16-yl)-N1,N1,N3,N3-tetraphenylbenzene-1,3-diamine (7d)

**5d** (133 mg, 0.29 mmol, 1 eq.), 5-chloro-N1,N1,N3,N3-tetraphenylbenzene-1,3-diamine **6d** (145 mg, 0.32 mmol, 1.1 eq.), sodium *tert*-butoxide (111 mg, 1.16 mmol, 4 eq.) tri-*tert*-butylphosphonium tetrafluoroborate (9 mg, 0.03 mmol, 11% mol) and Pd₂dba₃ (13 mg, 0.015 mmol, 5% mol) was dissolved in anhydrous toluene (4 ml) under nitrogen and refluxed overnight. The reaction was cooled to room temperature and extracted with dichloromethane, washed with brine and dried over Na₂SO₄ and concentrated in-vacuo to afford the crude product. The crude product was purified via column chromatography using the mixture of petroleum ether: dichloromethane 3:2 to obtain a pale green solid of **7d** (227 mg, 90% of yield). ¹H NMR (400 MHz, THF-d8 ) 8.22 (d, 1H, J=8.1 Hz), 7.90 (d, 1H, J=2.4 Hz), 7.61 (d, 1H, J=7.7), 7.43 (s, 1H), 7.40 (s, 1H), 7.20-7.25 (m, 18H), 7.05 (s, 1H), 6.99-6.95 (m, 3H), 6.95 (d, 2H, J=7.8 Hz), 6.76 (t, 1H, J=1.2 Hz), 6.80-6.82 (m, 2H), 6.75-6.70 (t, 1H, J=1.7 Hz), 6.62 (d, 2H, J=2.3 Hz), 1.49 (s, 9H), 1.43 (s, 9H)

### d. Synthesis of 2,12-di-tert-butyl-N,N,18-triphenyl-18H-9-oxa-4b,18,21b-triaza-13b-borabenzo[1,2]aceanthryleno[3,4-a]naphtho[1,2,3-hi]aceanthrylen-20-amine (Compound 4)

7d (0.8 g, 1 eq.) was completely dissolved in 8 mL of 1,2 dichlorobenzene (1,2-DCB) at room temperature. Then, boron tribromide (0.6 mL, 3 eq.) was dropped-wisely over the period of 5 minutes under an inert condition (nitrogen). Then, the mixture kept stirring at 180°C for 16 hours. The reaction progress was monitored by using thin layer chromatography technique. The reaction was terminated by adding methanol and concentrated under a reduced pressure. After the complete elimination of solvents from the crude mixture, dissolved completely in dichloromethane and filtered through a silica bed. After evaporation of solvents wet column chromatography (Silica) was performed to obtain the target final emitter (38% of yield). The structure was confirmed by mass (LC) and NMR spectrum.

### 1.5. Synthesis of Compounds 5-14 (Scheme 5)

### a. Synthesis of Compound 5

**Compound 5A** was obtained according to the procedure for compound **7d** presented in Synthesis **1.4,** with the exception of that instead of 1,2-dichlorobenzene, toluene was used and the proportion of **Compound 5A** and BBr₃ was 1.0:8.0.

### b. Synthesis of Compound 6

**Compound 6A** was obtained according to the procedure for compound **7d** presented in Synthesis **1.4,** with the exception of that instead of 1,2-dichlorobenzene, 1,3,5-trimethylbenzene was used and the proportion of **Compound 6A** and BBr₃ was 1.0:15.0.

### c. Synthesis of Compound 7

**Compound 7A** was obtained according to the procedure for compound **7d** presented in Synthesis **1.4,** with the exception of that instead of 1,2-dichlorobenzene, 1,2,4-trichlorobenzene was used and the proportion of **Compound 7A** and BBr₃ was 1.0:18.0.

### d. Synthesis of Compound 8

**Compound 8** was obtained according to the procedure for compound **8d** presented in Synthesis **1.4,** with the exception of that instead of 1,2-dichlorobenzene, 2,4-dichlorotoluene was used and the proportion of **Compound 8A** and BBr₃ was 1.0:8.0.

### e. Synthesis of Compound 9

**Compound 9A** was obtained according to the procedure for compound **7d** presented in Synthesis **1.4,** with the exception of that instead of 1,2-dichlorobenzene, 1,2,4-trichlorobenzene was used and the proportion of **Compound 9A** and BBr₃ was 1.0:20.0.

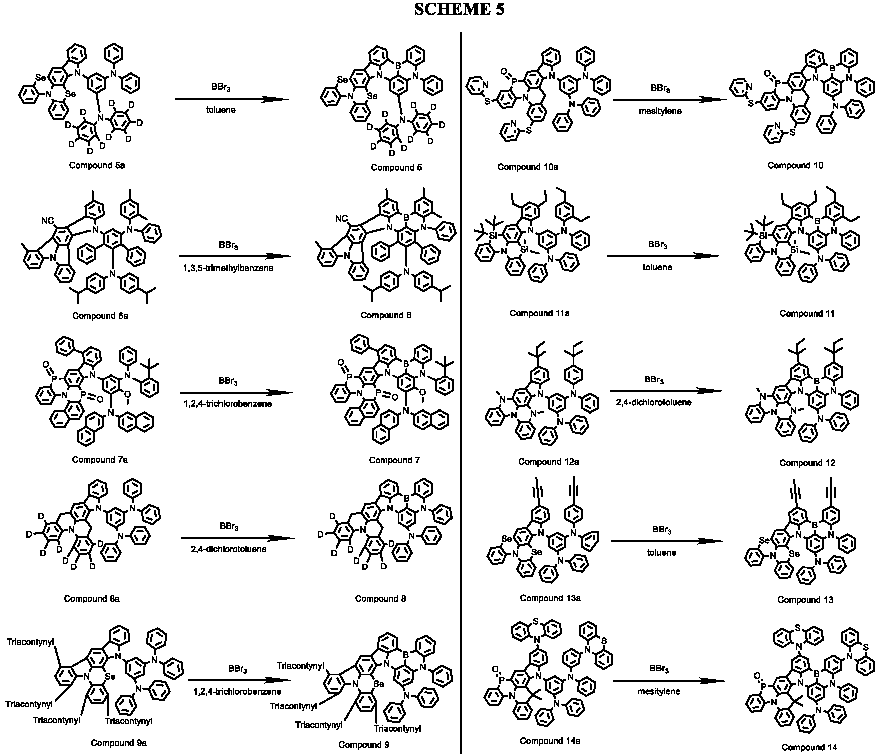

### f. Synthesis of Compound 10

**Compound 10A** was obtained according to the procedure for compound 7d presented in Synthesis 1.4, with the exception of that instead of 1,2-dichlorobenzene, mesitylene was used and the proportion of **Compound 10A** and BBr₃ was 1.0:10.0.

### g. Synthesis of Compound 11

**Compound 11A** was obtained according to the procedure for compound 7d presented in Synthesis 1.4, with the exception of that instead of 1,2-dichlorobenzene, toluene was used and the proportion of **Compound 11A** and BBr₃ was 1.0:12.0.

### h. Synthesis of Compound 12

**Compound 12A** was obtained according to the procedure for compound 7d presented in Synthesis 1.4, with the exception of that instead of 1,2-dichlorobenzene, 2,4-dichlorotoluene was used and the proportion of **Compound 12A** and BBr₃ was 1.0:11.0.

### i. Synthesis of Compound 13

**Compound 13A** was obtained according to the procedure for compound **7d** presented in Synthesis **1.4,** with the exception of that instead of 1,2-dichlorobenzene, toluene was used and the proportion of **Compound 13A** and BBr₃ was 1.0:14.0.

### j. Synthesis of Compound 14

**Compound 14A** was obtained according to the procedure for compound **7d** presented in Synthesis **1.4,** with the exception of that instead of 1,2-dichlorobenzene, mesitylene was used and the proportion of **Compound 14A** and BBr₃ was 1.0:20.0.

### Example 3. Photophysical properties of the compound

The photophysical properties of **Compounds 1** and **Compound 2** are presented in Table 1. The results show some improvements compared to the reference compound DBA-DI. Both **Compound 1 and Compound 2** exhibit a narrower FWHM, which enhances colour purity. For the emission maximum, both compounds demonstrate highly efficient pure-blue emission. **Compound 1** emits at 475 nm, **Compound 2** at 480 nm, while DBA-DI has an emission maximum at 467 nm. The HOMO and LUMO energy levels are 5.50 eV and 2.62 eV for DBA-DI, 5.31 eV and 2.67 eV for **Compound 1,** and 5.28 eV and 2.73 eV for **Compound 2,** respectively. These properties indicate that compounds are optimized for superior photophysical performance, particularly in terms of emission clarity and colour purity.

**Table 1. Summary of photophysical and electrochemical properties of DBA-DI (reference), Compound 1 - 4**

| **Emitter** | **λPL^{a} max^{b} (nm)** | **FWHM (Tol) (nm)** | **HOMO^{c} (eV)** | **LUMO^{d} (eV)** |
|---|---|---|---|---|
| DBA-DI (ref.) | 467 | 66 | 5.50 | 2.62 |
| **Compound 1** | 475 | 35 | 5.31 | 2.67 |
| **Compound 2** | 480 | 45 | 5.28 | 2.73 |
| **Compound 3** | 490 | 36 | 5.23 | 2.80 |
| **Compound 4** | 500 | 34 | 5.25 | 2.91 |

| | | | | |
|---|---|---|---|---|
| ^{a} photoluminescence quantum yield; ^{b} room temperature photoluminescence (PL) spectra (300 K) measured in toluene at 10⁻⁵ concentration; ^{c} the highest occupied molecular orbital; ^{d} the lowest unoccupied molecular orbital | | | | |

### Example 4. Electroluminescent device comprising the compound

The electroluminescent device comprising an anode, cathode, and emissive layer. The emissive layer is disposed between the anode and cathode. The electroluminescent device can comprise electrode 1 electrode 2 that can be made of aluminium (Al), ITO and platinum (Pt), fluorine doped tin oxide (FTO) and silver (Ag), ITO and calcium (Ca), ITO and barium (Ba), ITO and Mg-Al, zinc oxide (ZnO) and Al. The emissive layer can comprise a compound according to Formula I or their deuterated analogues (as presented in Example 1). The diode can comprise at least one of layer between the anode and cathode selected from: a hole injection layer; a hole transport layer; an electron transport layer, an electron blocking layer, a hole blocking layer, an electron injection layer; or a combination thereof. The hole transport layer can function as an electron blocking layer and the electron transport layer can function as a hole blocking layer. The diode can be made by thermal evaporation in high vacuum (PVD) or by solution methods, e.g. spin-coating, ink-jet printing.

Exemplary structures of electron-injecting materials in the electron injection layer (EIL):

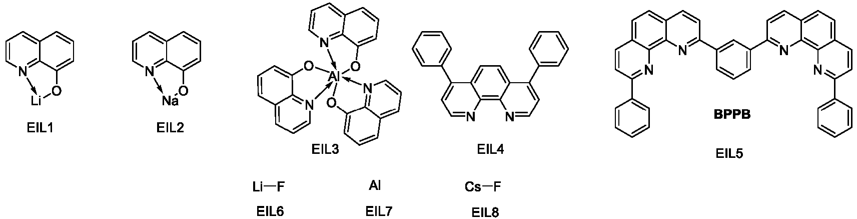

Exemplary structures of hole injection compounds in the hole injection layer (HIL) comprise the following:

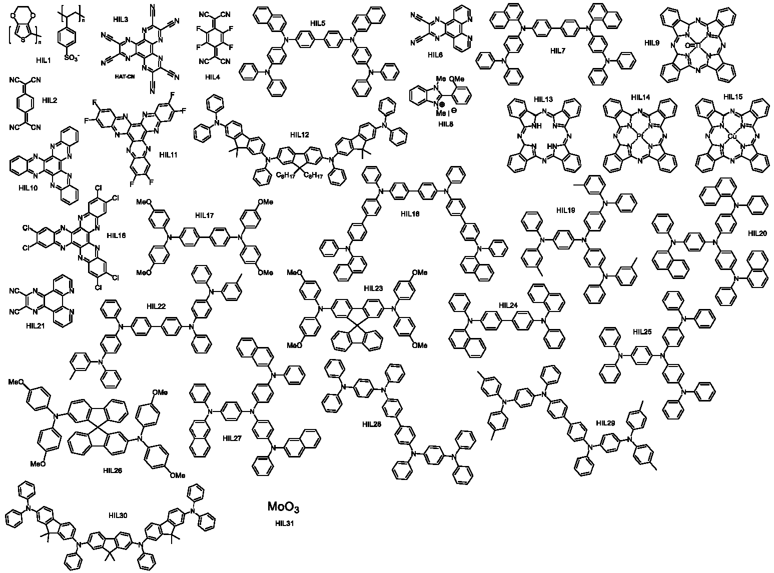

Exemplary structures of compounds of the hole transport layer (HTL):

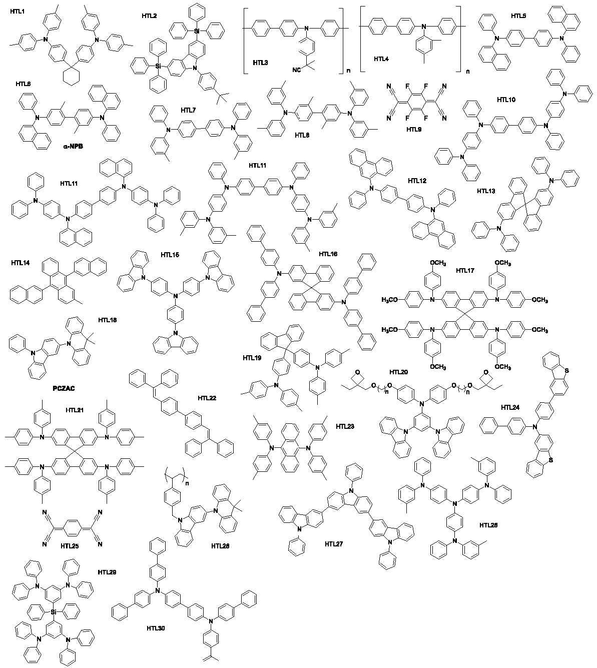

Exemplary structures of electron transporting compounds in the electron transport layer (ETL):

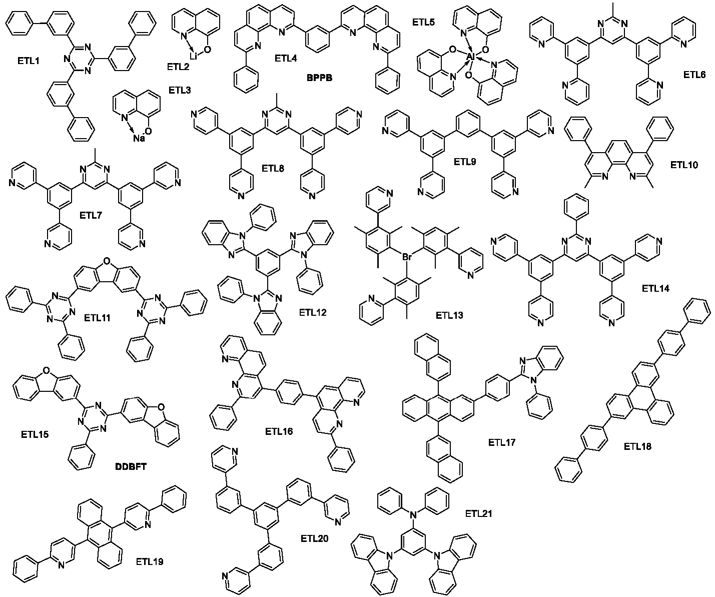

The examples of host (H) can be: 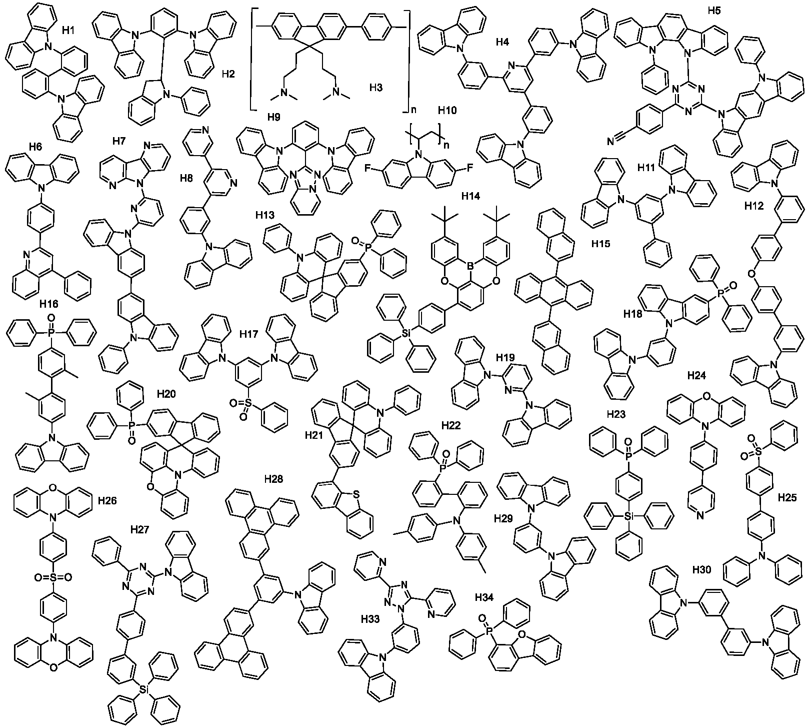 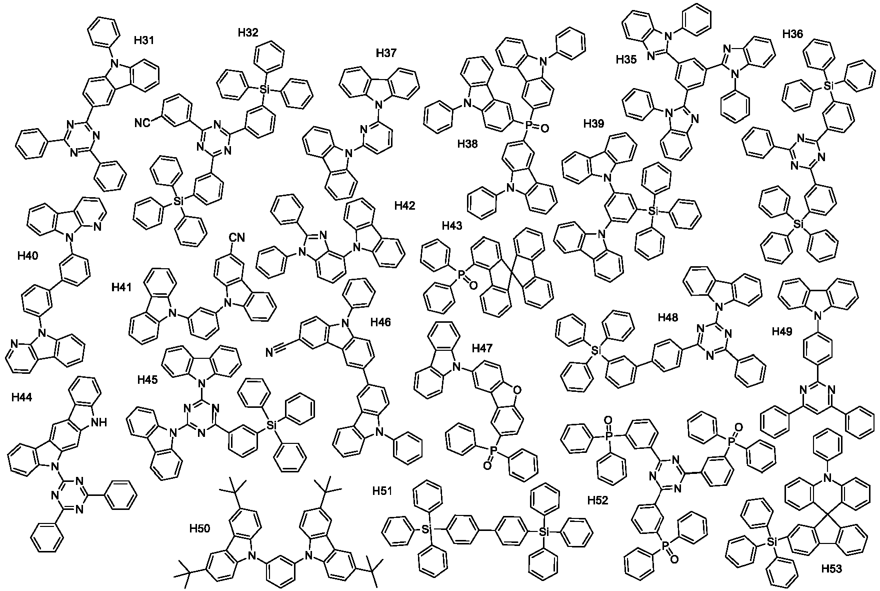 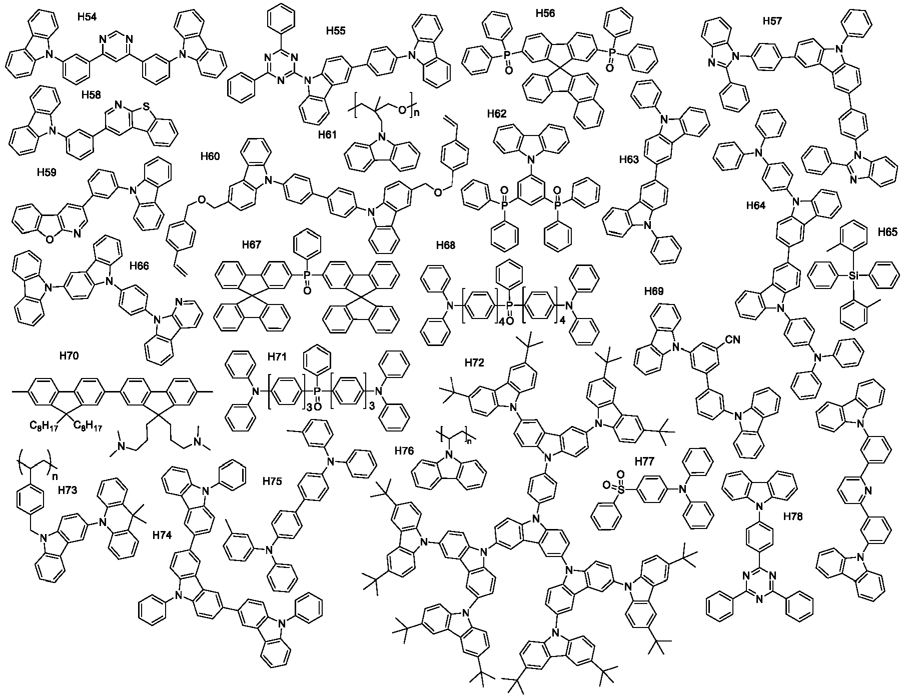 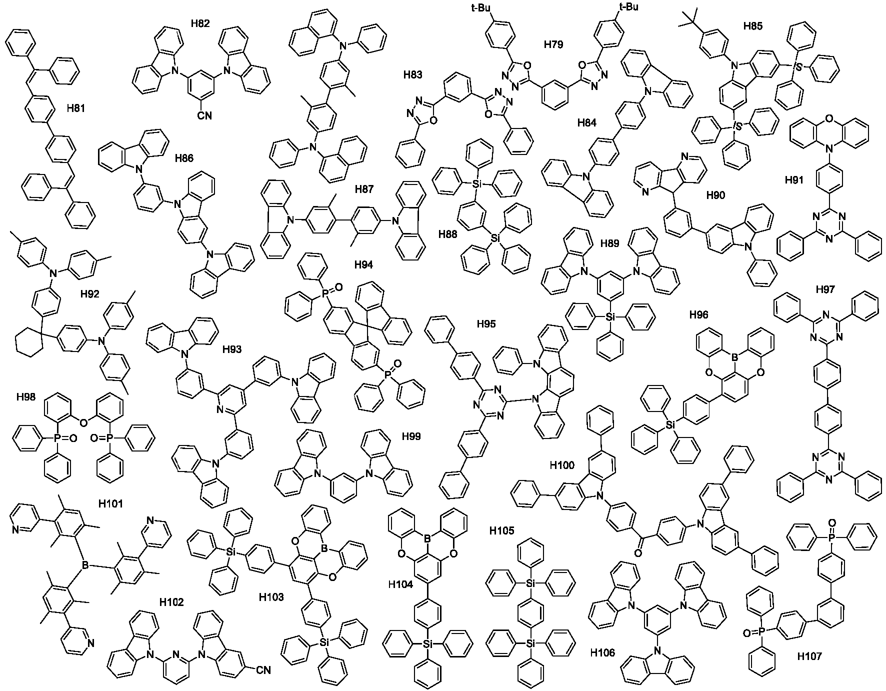 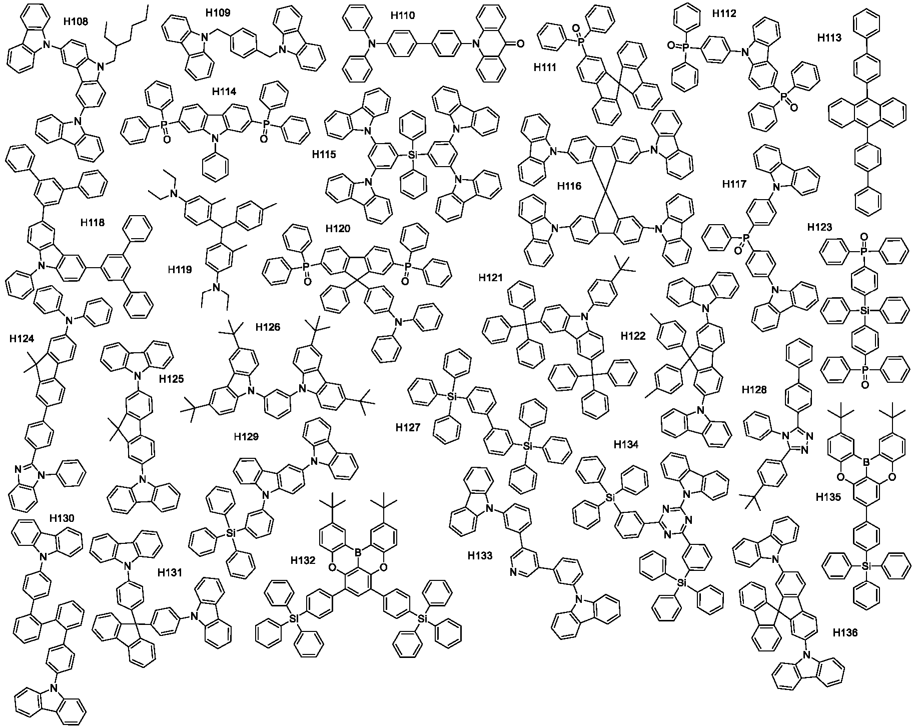 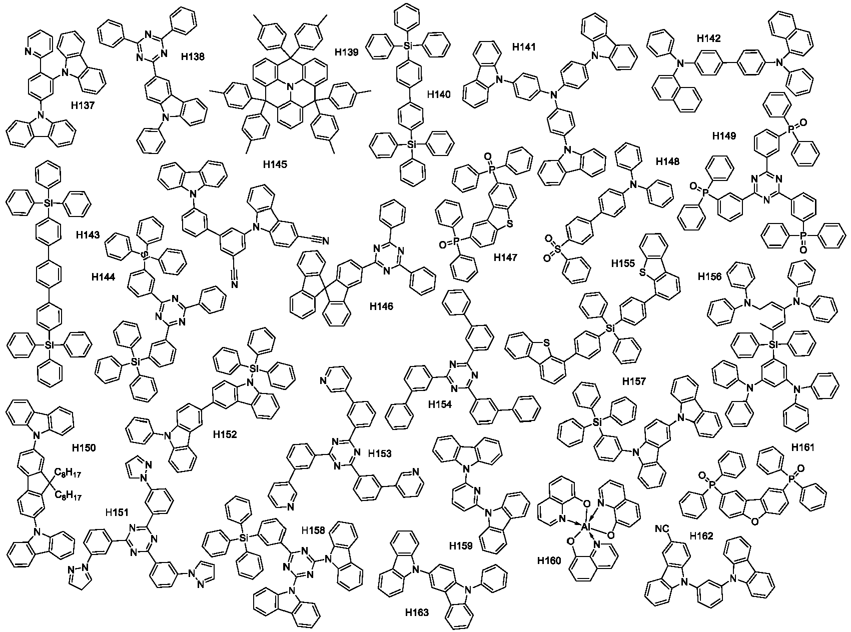 and deuterated analogues thereof. In the case of the hyper-fluorescence diodes, the TADF sensitizers host is selected from: 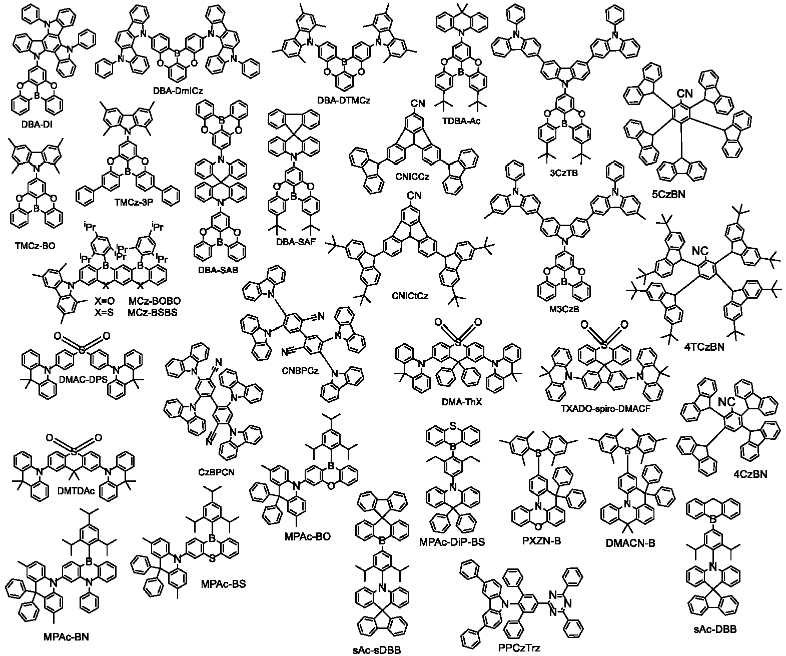 and deuterated analogues of thereof.

The diode according to the invention can comprise the host. The content of the host can constitute from 20.0% (w./w.) to 99.9% (w./w.) of the emissive layer. The content of the host can constitute from 20.0%, 22.5%, 25.0%, 27.5%, 30.0%, 35.0%, 40,0%, 45.0%, 50.0%, 55.0%, 60.0%, 62.5%, 65.0%, 70.0%, 75.0%, 80.0%, 85.0%, 87.5%, 90.0%, 92.5%, 95.0% (w./w.) to 99.0% (w./w.) of the emissive layer. The diode according to the invention comprises the TADF sensitizers host. The content of the TSH compound can be from 0.01% (w./w.) to 99.9% (w./w.) of the emissive layer. The content of the fluorescence dopant or a can be from 0.05%, 0.1%, 1.0%, 1.5%, 2,0%, 2.5%, 3.0%, 5.0%, 7.0%, 8.0%, 9.0% (w./w.) to 9.5%, 10.0%, 15.0%, 20.0%, 25.0%, 30.0%, 35.0%, 40.0%, 45.0%, 50.0%, 55.0%, 60.0%, 65.0%, 70.0%, 75.0%, 80.0%, 85.0%, 90.0%, 95.0% (w./w.) of the emissive layer. The diode according to invention comprises the fluorescence dopant according to Formula I. The content of the fluorescence dopant can be from 0.01% (w./w.) to 99.9% (w./w.) of the emissive layer. The content of the fluorescence dopant or a can be from 0.05%, 0.1%, 1.0%, 1.5%, 2,0%, 2.5%, 3.0%, 5.0%, 7.0%, 8.0%, 9.0% (w./w.) to 9.5%, 10.0%, 15.0%, 20.0%, 25.0%, 30.0%, 35.0%, 40.0%, 45.0%, 50.0%, 55.0%, 60.0%, 65.0%, 70.0%, 75.0%, 80.0%, 85.0%, 90.0%, 95.0% (w./w.) of the emissive layer. The diode according to the invention can comprise a matrix. The matrix can be passive or active. The diode according to invention can emit light with a maximum wavelength of 350 nm to 2 500 nm. The diode according to invention can emit light with a maximum wavelength of 400, 450, 500, 550, 600, 650, 700, 750, 800, 900 nm to 1 000 nm. The processes for obtaining chemical compounds presented in the diode according to the invention such as: dopants, hosts, the compounds of the hole injection layer, hole transport layer, electron transport layer, electron blocking layer, hole blocking layer, electron injection layer, are well known in the state of the art. Exemplary current-spectral measurements for exemplary electroluminescent diodes are presented in **Table 2 and Table 3.**

**Table 2. Current-spectral measurements for the hyperfluorescence diodes according to the invention**

| **Device NO.** | **Host/Emitter/HF weight ratio (wt. %)** | **EQE (max/@ 5 000 cd/m²) (%)** | **C.E. (max/@ 5 000 cd/m²) (cd/A)** | **ELₘₐₓ (nm)** | **LT₉₀ at 1 000 cd/m² (h)** | **FWHM (nm)** |
|---|---|---|---|---|---|---|
| **1** | 2CzPy/ DBA-DI/**Com 1** 59/40/1 | 14.1/13.7 | 35.4/33.6 | 480 | 4.4 | 48 |
| **2** | 2CzPy/ DBA-DI/**Com 1** 58/40/2 | 13.8/13.2 | 34.7/32.5 | 480 | 3.6 | 46 |
| **3** | 2CzPy/ DBA-DI/**Com 2** 59/40/1 | 18.5/16.5 | 37.3/32.6 | 490 | 6.5 | 61 |
| **4** | 2CzPy/ DBA-DI/**Com 2** 58/40/2 | 14.4/13.3 | 29.1/26.0 | 491 | 3.5 | 58 |
| **5** | 2CzPy/ DBA-DI/**Com 3** 57/40/3 | 15.2/14.6 | 33.5/29.7 | 500 | 4.8 | 46 |
| **6** | 2CzPy/ DBA-DI/**Com 4** 57/40/3 | 17.3/16.7 | 34.9/32.8 | 510 | 4.4 | 43 |

| | | | | | | |
|---|---|---|---|---|---|---|
| Abbreviations: EQE - external quantum efficiency; C.E.- Current Efficiency; ELₘₐₓ - a maximum wavelength of the diode emission; LT₉₀ - operational lifetime of diode, wherein luminance decreases to 90% of the original FWHM - full width at half maximum; Com - Compound | | | | | | |

**Table 3. Current-spectral measurements for the fluorescence diodes according to the invention**

| **Device NO.** | **Host (95 wt.%)/ Emitter (5 wt.%)** | **EQE (Max/@ 5 000 cd/m²) (%)** | **C.E. (Max/@ 5 000 cd/m²) (cd/A)** | **ELₘₐₓ (nm)** | **LT₉₀ at 1 000 cd/m² (h)** |
|---|---|---|---|---|---|
| **7** | DPFAn/ **Com 1** | 5.9/5.1 | 4.8/4.1 | 478 | 6.3 |
| **8** | DPFAn/ **Com 2** | 6.4/5.7 | 5.1/4.8 | 483 | 7.2 |
| **9** | DPFAn/ **Com 3** | 5.7/5.4 | 4.7/4.1 | 494 | 6.4 |
| **10** | DPFAn/ **Com 4** | 6.2/5.3 | 5.0/4.7 | 505 | 7.0 |

The diodes can comprise an anode, cathode, and organic emissive layer, disposed between an anode and cathode.

The exemplary composition of these diodes according to the invention is presented in **Table 4** and **Table 5.**

**Table 4. The exemplary composition of hyperfluorescence diodes according to the invention**

| **Device NO.** | **Anode** | **HIL 7 nm** | **HTL 53 nm** | **EBL 10 nm** | **Host** | **Sensitizer (wt. %)** | **Final Dopant (wt. %)** | **HBL 10 nm** | **ETL 25 nm** | **ElL/Cathode 1.4/90 nm** |
|---|---|---|---|---|---|---|---|---|---|---|
| **1** | ITO | HATCN | PCBBiF | PCzAc | 2CzPy | DBA-DI 40 | **Com 1** 1 | DDBFT | BPPB | Liq/Al |
| **2** | ITO | HATCN | PCBBiF | PCzAc | 2CzPy | DBA-DI 40 | **Com 1** 5 | DDBFT | BPPB | Liq/Al |
| **3** | ITO | HATCN | PCBBiF | PCzAc | 2CzPy | DBA-DI 40 | **Com 2** 1 | DDBFT | BPPB | Liq/Al |
| **4** | ITO | HATCN | PCBBiF | PCzAc | 2CzPy | DBA-DI 40 | **Com 2** 2 | DDBFT | BPPB | Liq/Al |
| **5** | ITO | HATCN | PCBBiF | PCzAc | 2CzPy | DBA-DI 40 | **Com 3** 3 | DDBFT | BPPB | Liq/Al |
| **6** | ITO | HATCN | PCBBiF | PCzAc | 2CzPy | DBA-DI 40 | **Com 4** 3 | DDBFT | BPPB | Liq/Al |
| **11** | ITO | F4TCNQ | DTAF | mCPBC | mCBP-CN | DBA-DmICz 40 | **Com 5** 1 | PPF | B3PyPB | LiF/Al |
| **12** | ITO | PPDN | Spiro-OMeTAD | mCBP | mCBP-CN | TmCz-BO 40 | **Com 6** 3 | PPF | TPBi | LiFAl |
| **13** | ITO | MoO3 | m-MTDATA | mCPPO1 | PPF | PXZN-B 40 | **Com 7** 1 | T2T | ZADN | Liq/Al |
| **14** | ITO | TDATA | DTAF | TSPO1 | mCPCN | PXZN-B 30 | **Com 8** 2 | PPF | DPPyA | Liq/Al |
| **15** | ITO | F4TCNQ | Tris-PCz | mCPPO1 | PPF | DBA-DmICz 30 | **Com 9** 3 | T2T | BTB | LiF/Al |
| **16** | ITO | F4TCNQ | TTPA | mCPPO1 | mCBP-CN | TmCz-BO 30 | **Com 10** 3 | B3PyPB | TPBi | LiFAl |
| **17** | ITO | PPDN | m-MTDATA | mCPBC | PPF | M3CzB 40 | **Com 11** 2 | DDBFT | DPPyA | Liq/Al |
| **18** | ITO | HATCN | NPB | TSPO1 | PPF | M3CzB 35 | **Com 12** 2 | BPhen | BPhen | LiF/Al |
| **19** | ITO | TDATA | NPB | CBP | 2CzPy | DBA-DmICz 40 | **Com 13** 2 | PPF | TPBi | Liq/Al |
| **20** | ITO | PPDN | TTPA | mCBP | mCPCN | TmCz-BO 35 | **Com 14** 1 | TSPO1 | B4PymPm | Liq/Al |

| | | | | | | | | | | |
|---|---|---|---|---|---|---|---|---|---|---|
| Abbreviations: HIL - hole injection layer; HTL - hole transport layer; EBL - electron blocking layer; HBL - hole blocking layer; ETL - electron transport layer; EIL - electron injection layer | | | | | | | | | | |

**Table 5. The exemplary composition of fluorescence diodes according to the invention**

| **Device NO.** | **Anode** | **HIL 7 nm** | **HTL 68 nm** | **Host 25 nm** | **Final dopant 5 wt.%** | **ETL 25 nm** | **ElL/cathode 1.5/90 nm** |
|---|---|---|---|---|---|---|---|
| **7** | ITO | HATCN | PCBBiF | DPFAn | **Com 1** | BPPB | Liq/Al |
| **8** | ITO | HATCN | PCBBiF | DPFAn | **Com 2** | BPPB | Liq/Al |
| **9** | ITO | HATCN | PCBBiF | DPFAn | **Com 3** | BPPB | Liq/Al |
| **10** | ITO | HATCN | PCBBiF | DPFAn | **Com 4** | BPPB | Liq/Al |
| **21** | ITO | HATCN | DTAF | DPFAn | **Com 5** | DPPyA | Liq/Al |
| **22** | ITO | HATCN | TTPA | DPFAn | **Com 6** | TPBi | Liq/Al |
| **23** | ITO | HATCN | Spiro-OMeTAD | DPFAn | **Com 7** | B3PyPB | Liq/Al |
| **24** | ITO | HATCN | DTAF | DPFAn | **Com 8** | BPPB | Liq/Al |
| **25** | ITO | HATCN | NPB | DPFAn | **Com 9** | ZADN | Liq/Al |
| **26** | ITO | HATCN | Tris-PCz | DPFAn | **Com 10** | B4PymPm | Liq/Al |
| **27** | ITO | HATCN | Tris-PCz | PFAn | **Com 11** | DPPyA | Liq/Al |
| **28** | ITO | HATCN | TTPA | DPFAn | **Com 12** | B3PyPB | Liq/Al |
| **29** | ITO | HATCN | m-MTDATA | DPFAn | **Com 13** | ZADN | Liq/Al |
| **30** | ITO | HATCN | Spiro-OMeTAD | DPFAn | **Com 14** | B3PyPB | Liq/Al |

### Example 5. The use of the consumer product comprising the device

A consumer product can comprise the device according to the invention. The consumer product can be selected from a flat panel display, a computer monitor, a medical monitor, a television, a billboard, a light for interior or exterior illumination/signalling, a heads-up display, a fully or partially transparent display, a flexible display, a laser printer, a telephone, a cell phone, tablet, a phablet, a personal digital assistant, a wearable device, a laptop computer, a watch, a backlight, a digital camera, a camcorder, a 3-D display, a virtual reality or augmented reality display, a vehicle, a video walls comprising multiple displays tiled together, a theatre, stadium screen, and a sign.

Use of the device according to the invention can be as follows: a display screen or illumination device, an electroluminescent display device, an organic photovoltaic device, or a sensing device.

## Claims

1. A boron-containing compound according to Formula I: 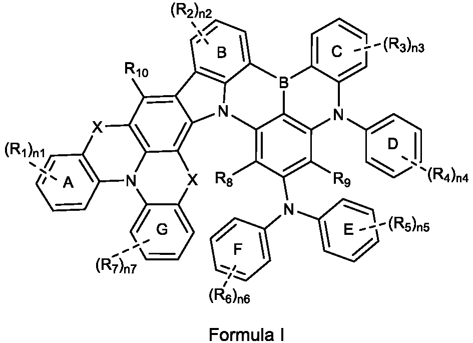 wherein:
**R₁ - R₇,** together or independently, are hydrogen, deuterium, halogen, cyano, nitro, hydrazine, hydrazone, hydroxyl, C₁-C₃₀ alkyl, C₂-C₃₀ alkenyl, C₂-C₃₀ alkynyl, C₁-C₁₀ alkoxy group, C₃-C₁₀ cycloalkyl, C₃-C₁₀ cycloalkenyl, C₅-C₂₀ heterocycloalkyl, C₅-C₂₀ heterocycloalkenyl group, C₃-C₁₀ cycloalkynyl group, C₅-C₂₀ heterocycloalkynyl group, C₆-C₆₀ aryl, C₄-C₆₀ heteroaryl group, C₅-C₆₀ aryloxy, C₄-C₆₀ heteroaryloxy group, C₂-C₆₀ ether group, C₆-C₆₀ thioaryl, C₄-C₆₀ heterothioaryl, C₁-C₁₀ amino, C₁-C₁₀ alkylamino, C₁-C₁₀ dialkylamino, C₆-C₆₀ arylamino, C₆-C₆₀ diarylamino, C₆-C₆₀ heteroarylamino group, C₆-C₆₀ heterodiarylamino group, C₄-C₆₀ non-aromatic fused polycyclic group, C₃-C₆₀ non-aromatic fused heteropolycyclic group or their deuterated analogues thereof;
**R₈ - R₁₀,** together or independently, are hydrogen, deuterium, halogen, cyano, nitro, hydrazine, hydroxyl, C₅-C₂₀ heterocycloalkyl, C₃-C₁₀ cycloalkynyl group, C₅-C₂₀ heterocycloalkynyl group, C₆-C₆₀ aryl, C₄-C₆₀ heteroaryl group, C₅-C₆₀ aryloxy, C₄-C₆₀ heteroaryloxy group, C₆-C₆₀ thioaryl, C₆-C₆₀ arylamino or their deuterated analogues.
**n₁, n₃, and n₇,** are the same as or different from each other, is an integer from 0 to 4,
**n₂** is an integer from 0 to 3,
**n₄** - **n₆,** are the same as or different from each other, is an integer from 0 to 5,
when **n₁** is an integer of 2, adjacent groups among **R₁** may be bonded to each other to form an aryl ring or a heteroaryl ring together with the **ring A** and at least one hydrogen atom in the ring thus formed may be further substituted,
when **n₂** is an integer of 2, adjacent groups among **R₂** may be bonded to each other to form an aryl ring or a heteroaryl ring together with the **ring B** and at least one hydrogen atom in the ring thus formed may be further substituted,
when **n₃** is an integer of 2, adjacent groups among **R₃** may be bonded to each other to form an aryl ring or a heteroaryl ring together with the **ring C** and at least one hydrogen atom in the ring thus formed may be further substituted,
when **n₄** is an integer of 2 or 4, adjacent groups among **R₄** may independently be bonded to each other to form an aryl ring or a heteroaryl ring together with the **ring D** and at least one hydrogen atom in the ring thus formed may be further substituted,
when **n₅** is an integer of or 4, adjacent groups among **R₅** may independently be bonded to each other to form an aryl ring or a heteroaryl ring together with the **ring E** and at least one hydrogen atom in the ring thus formed may be further substituted,
when **n₆** is an integer of 2 or 4, adjacent groups among **R₆** may independently be bonded to each other to form an aryl ring or a heteroaryl ring together with the **ring F** and at least one hydrogen atom in the ring thus formed may be further substituted,
when **n₇** is an integer of 2, adjacent groups among **R₇** may be bonded to each other to form an aryl ring or a heteroaryl ring together with the **ring G** and at least one hydrogen atom in the ring thus formed may be further substituted,
**X** is a single bond, O, S, Se, N-R₁₁, C(-R₁₁)₂, Si(-R₁₁)₂, P(=O),
**R₁₁** is each independently hydrogen, deuterium, halogen, cyano, nitro, hydrazine, hydrazone, C₁-C₃₀ alkyl, C₂-C₃₀ alkenyl, C₃-C₁₀ cycloalkyl, C₃-C₁₀ cycloalkenyl, C₁-C₁₀ heterocycloalkyl, C₆-C₆₀ aryl, C₅-C₂₀ aryloxy, C₅-C₂₀ heteroaryloxy group or their deuterated analogues.

2. The compound according to claim 1, wherein the compound is selected from:

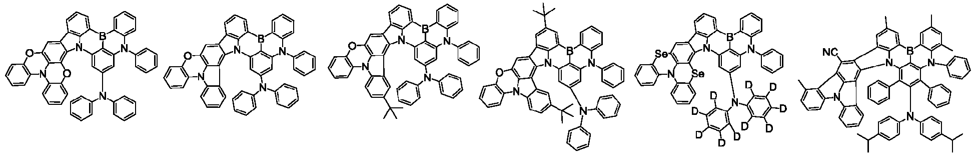

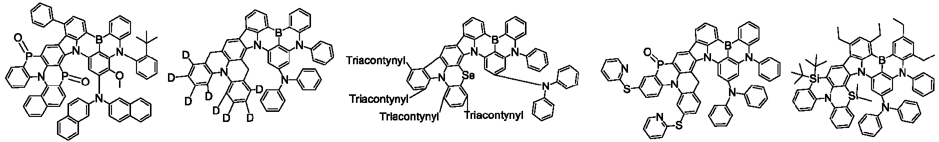

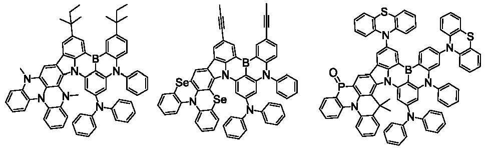

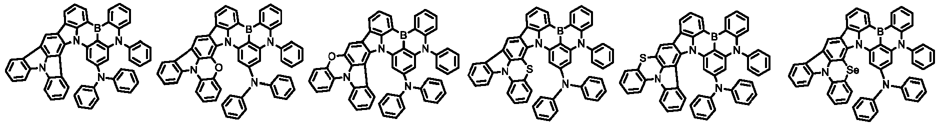

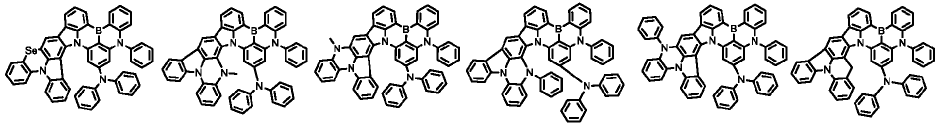

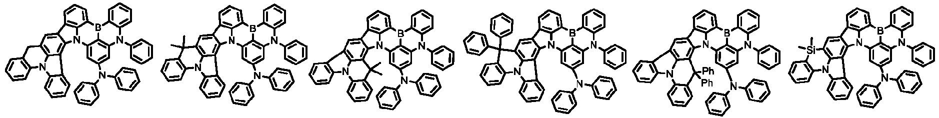

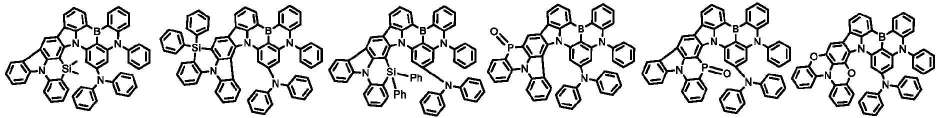

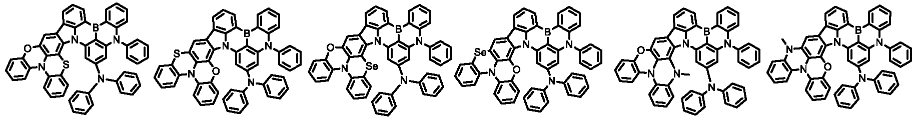

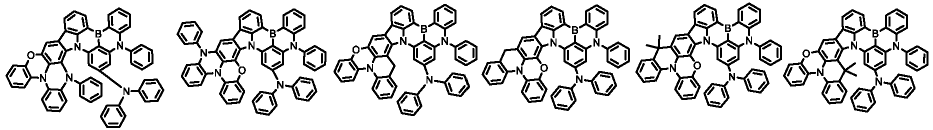

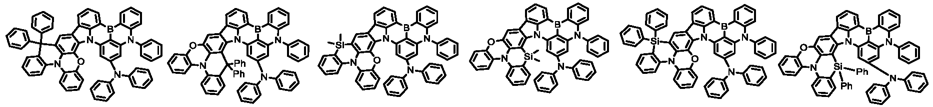

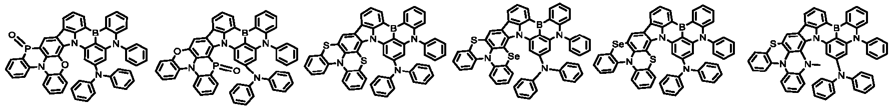

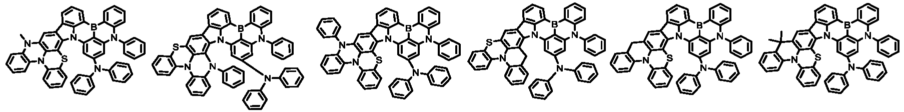

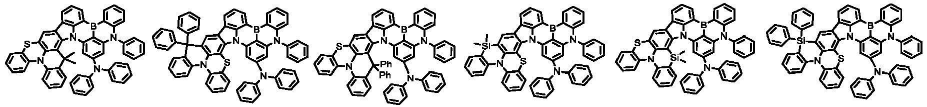

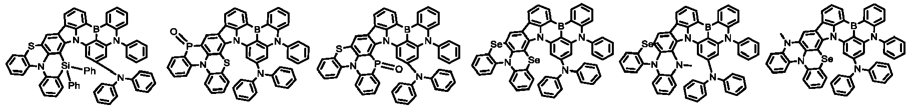

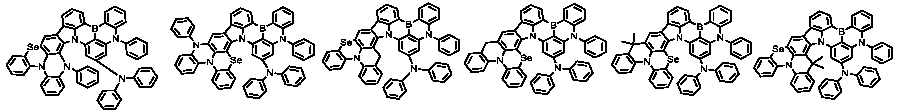

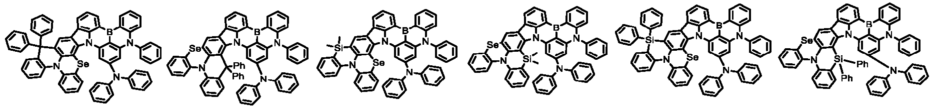

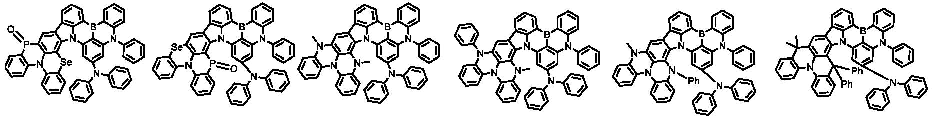

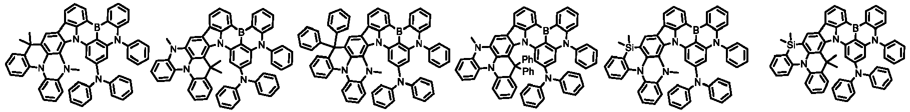

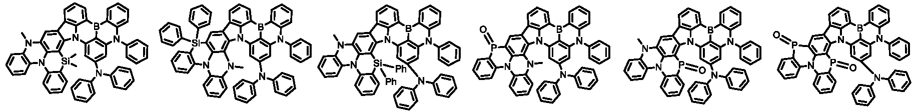

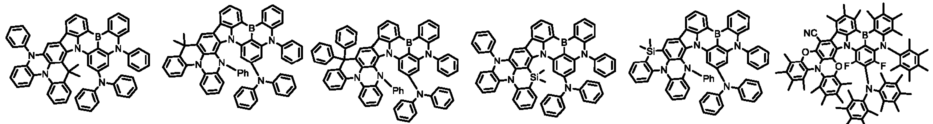

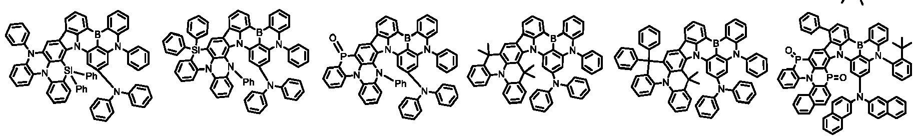

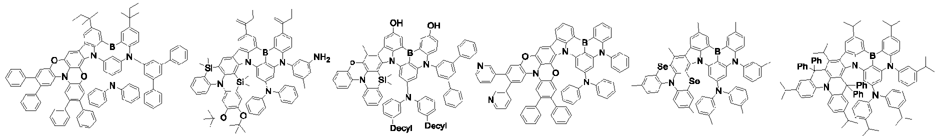

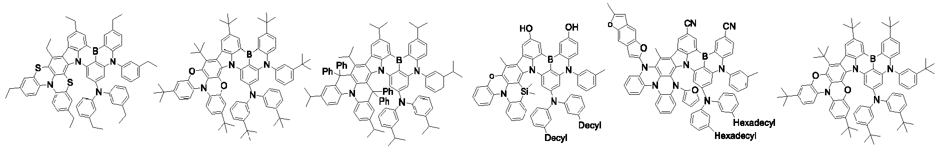

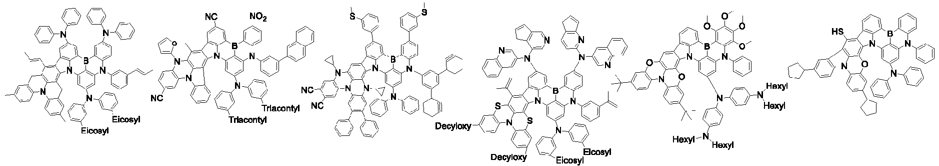

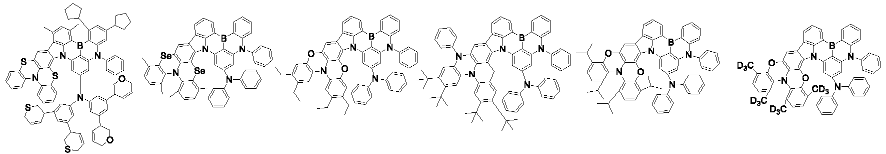

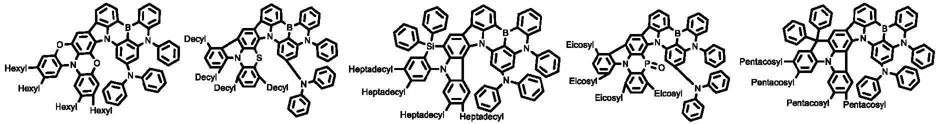

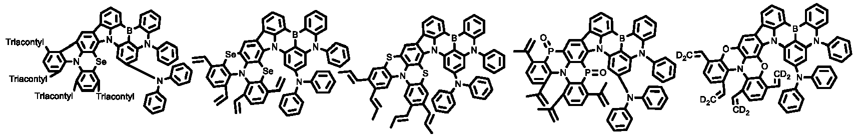

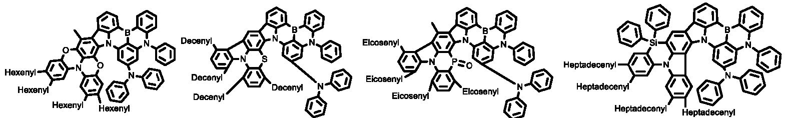

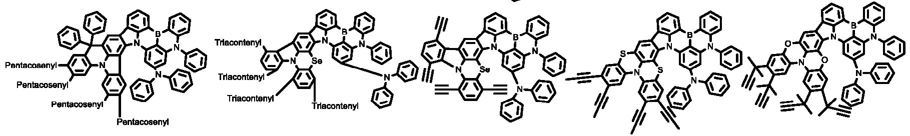

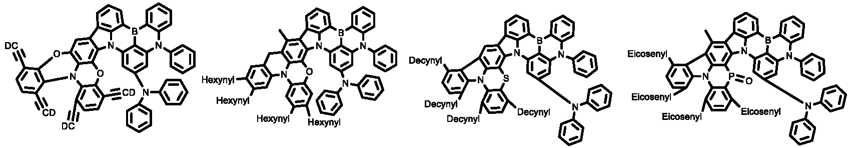

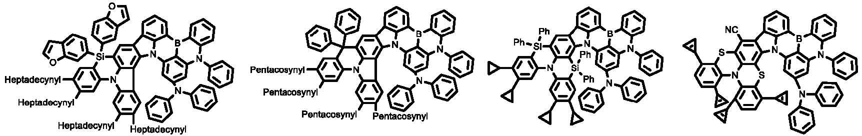

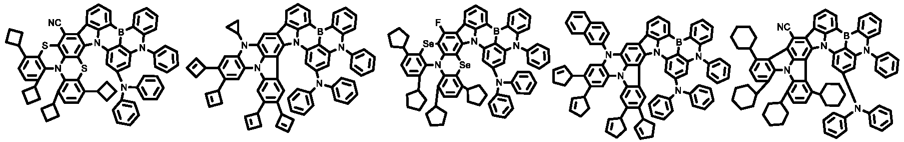

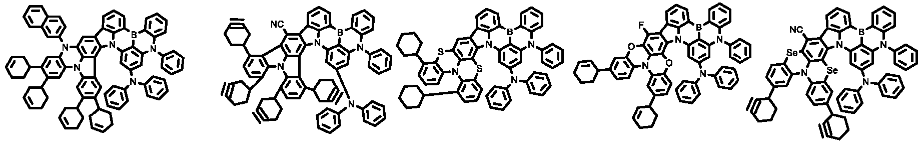

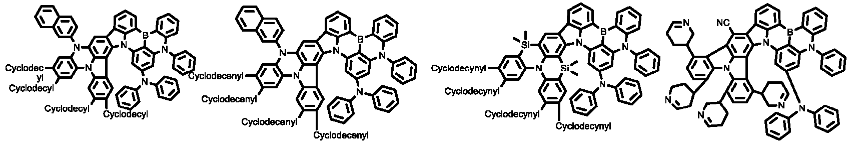

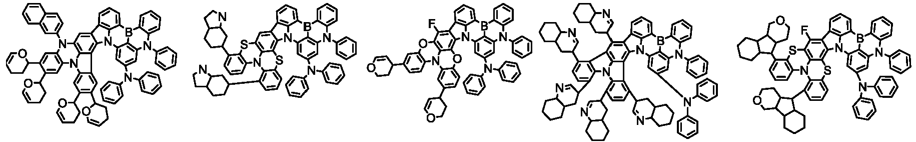

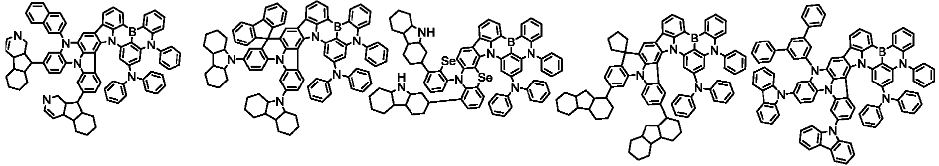

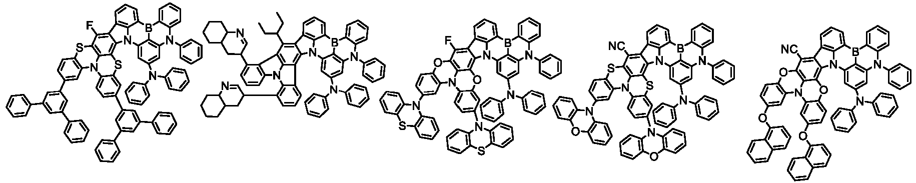

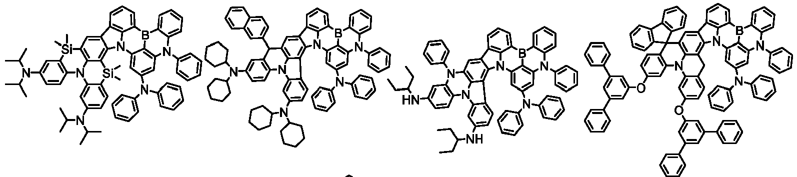

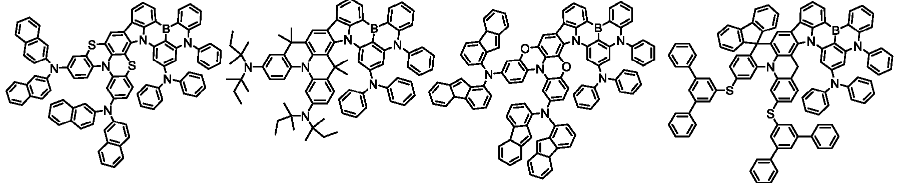

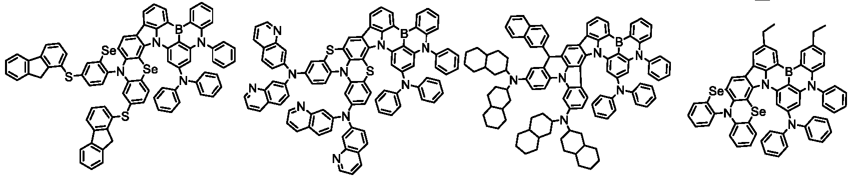

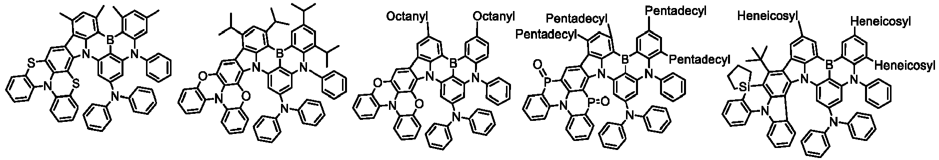

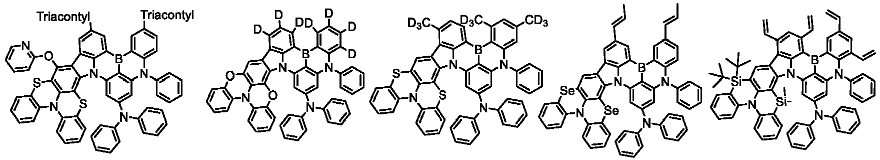

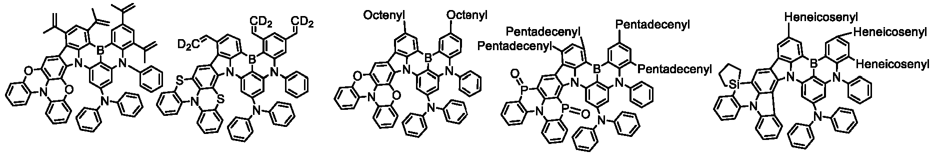

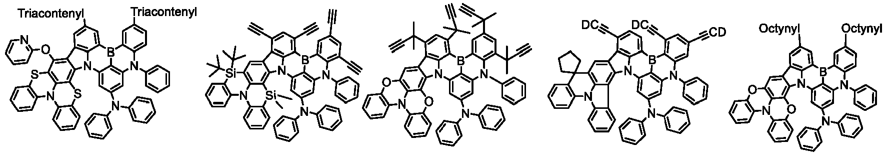

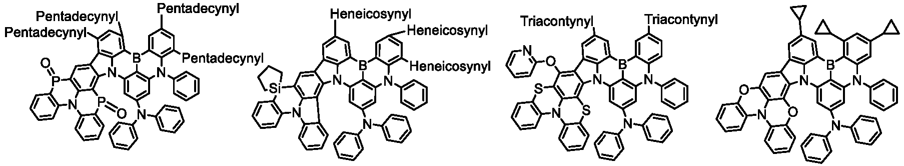

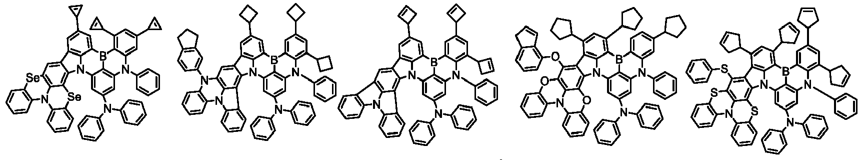

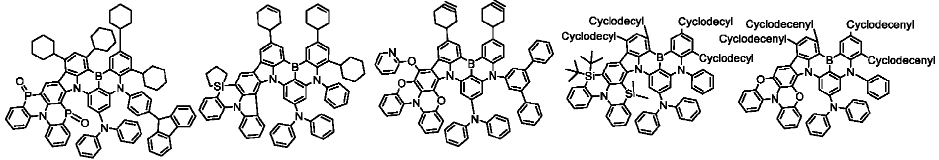

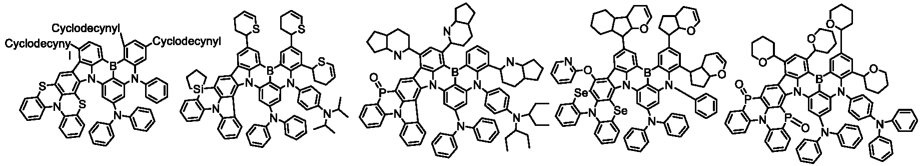

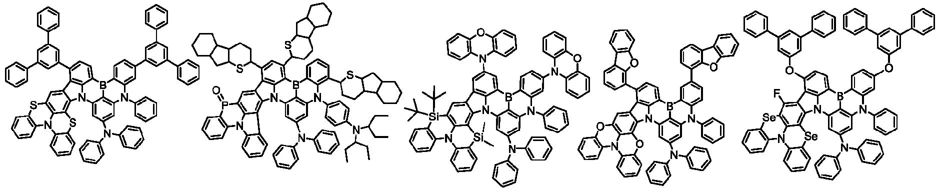

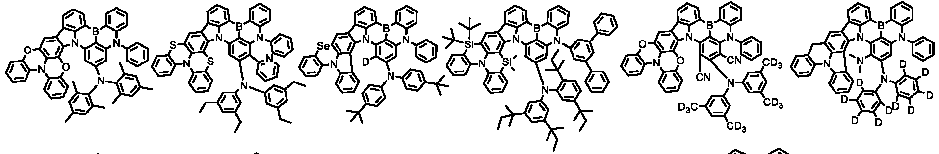

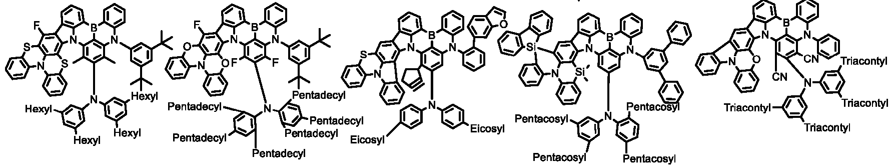

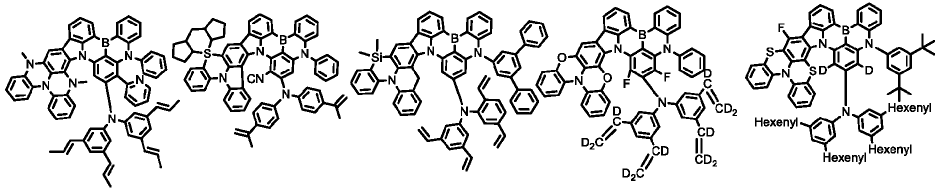

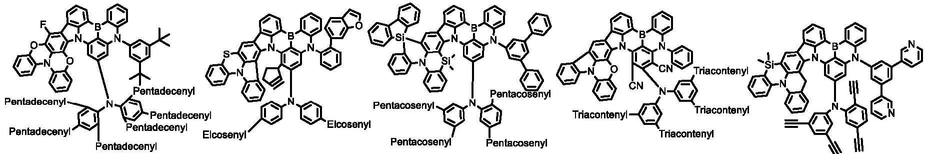

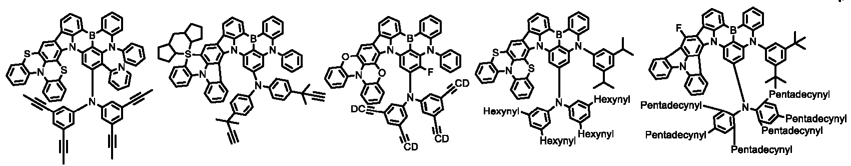

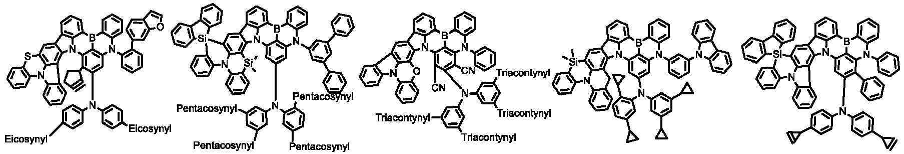

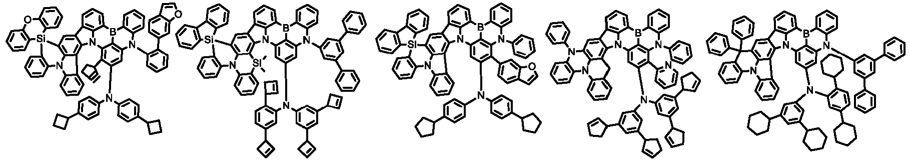

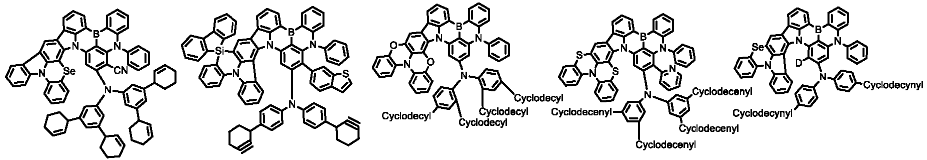

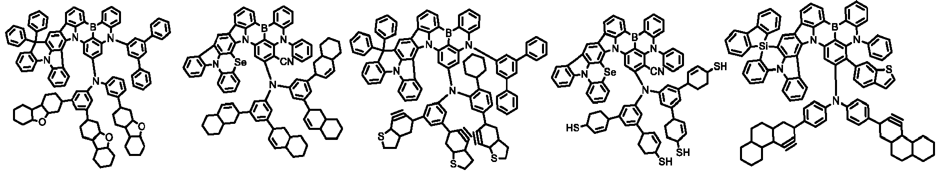

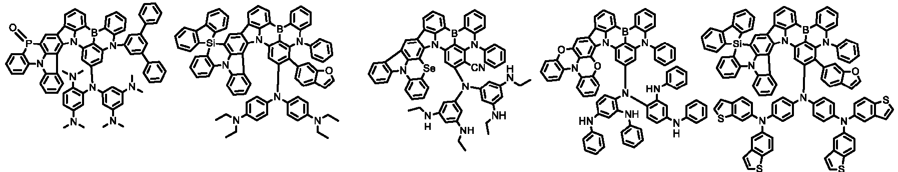

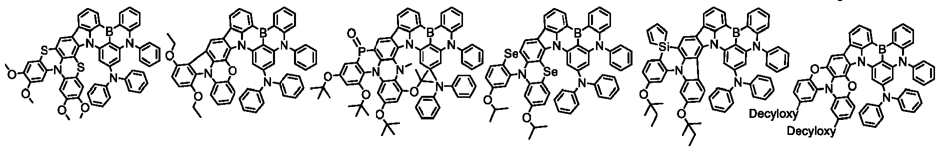

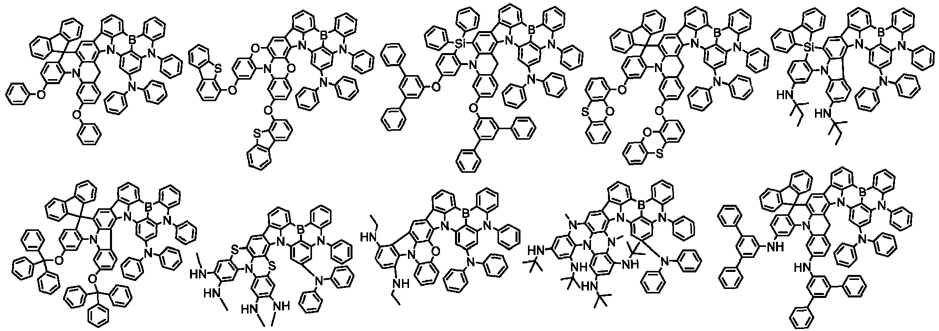

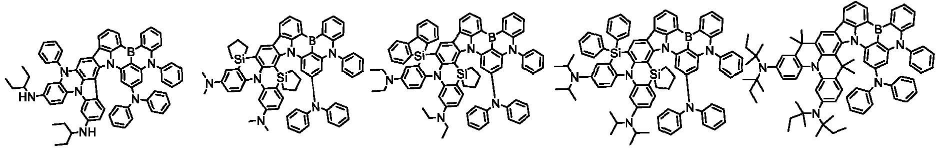

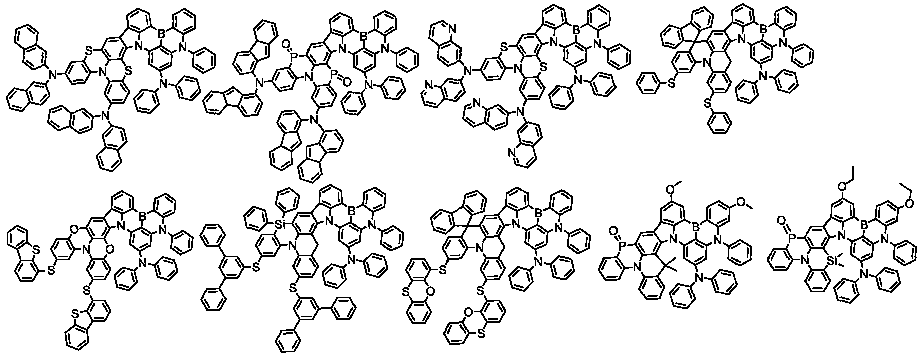

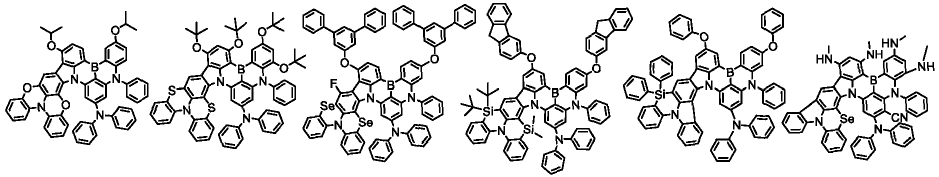

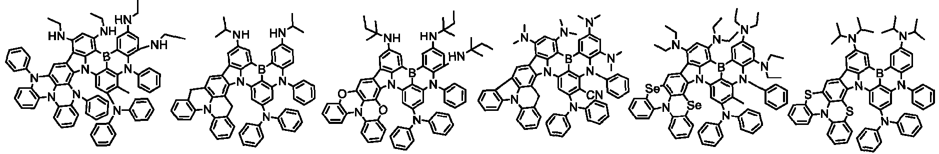

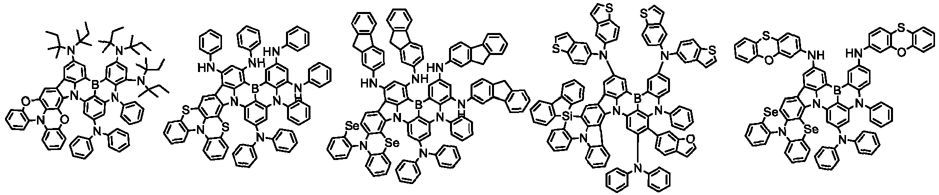

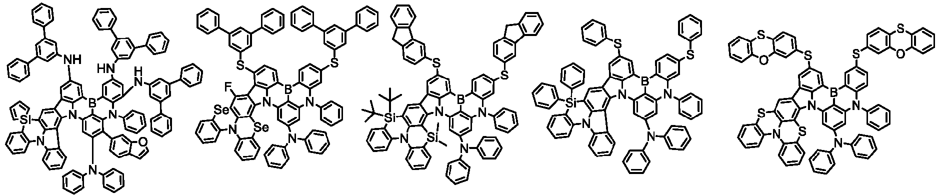

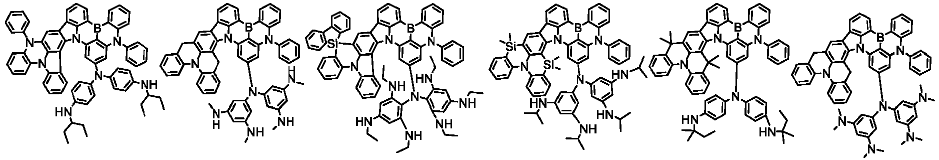

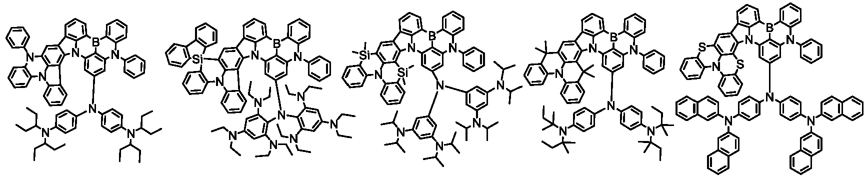

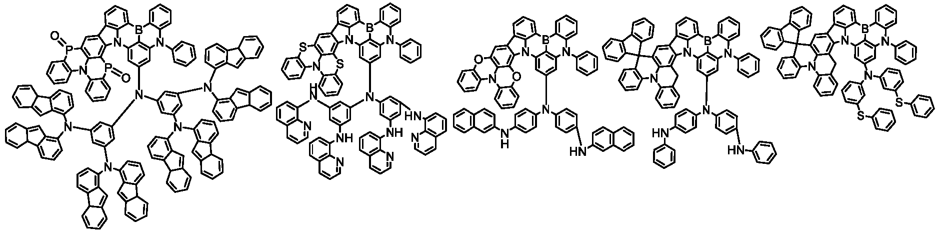

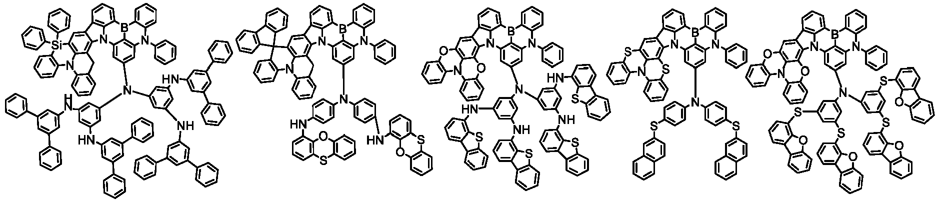

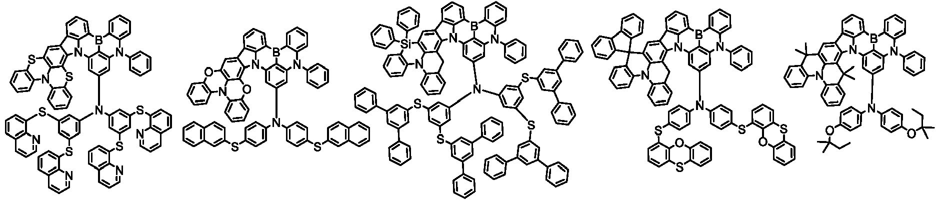

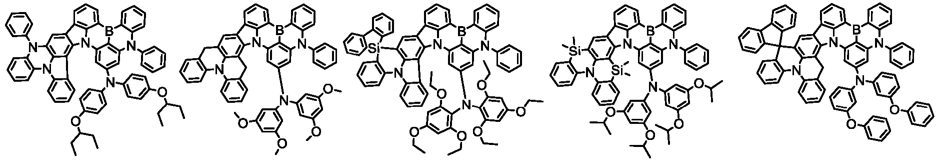

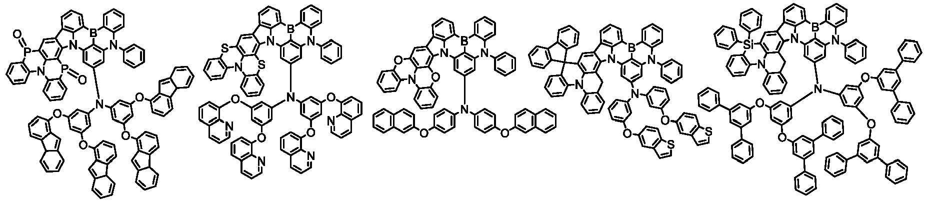

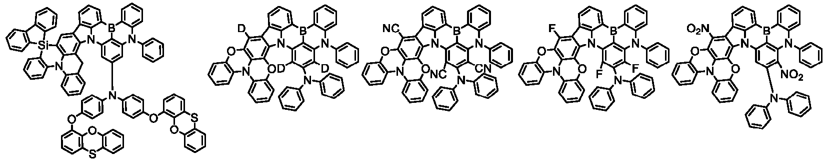

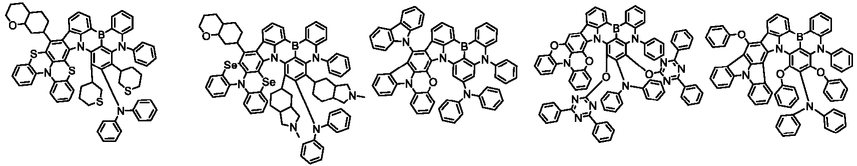

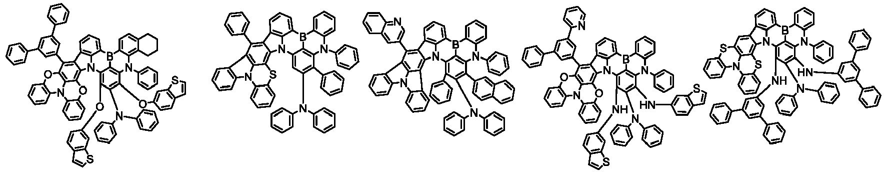

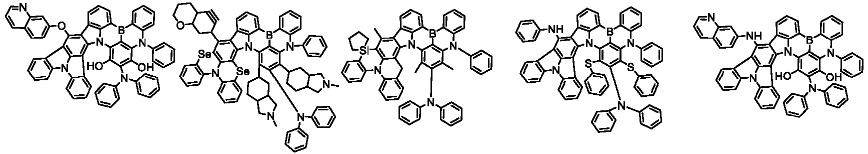

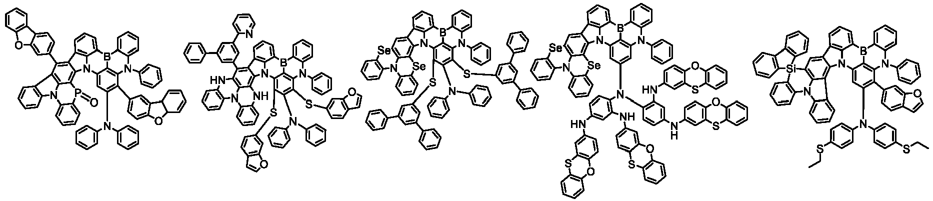

3. A process for obtaining the compound according to claim 1 or 2, comprising a step reacting a compound according to Formula II 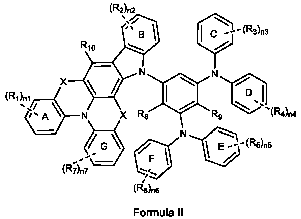 wherein
**R₁ - R₁₁, n₁ - n₇, X, A - G** are the same as in Formula I;
with boron tribromide in an organic solvent solution in an inert gas atmosphere.

4. The process according to claim 3, wherein the inert gas is nitrogen, carbon dioxide, argon, or other noble gas.

5. The process according to claim 3 or 4, wherein the molar proportion of compound according to Formula II to boron tribromide is from 1.0:8.0 to 1.0:20.0.

6. The process according to any one claim 3-5, wherein the solution is 1,2-dichlorobenzene, toluene, mesitylene, 1,2,4-trichlorobenzene, 2,4-dichlorotoluene, or 1,3,5-trimethylbenzene.

7. An emissive layer comprising the compound according to claim 1 or 2.

8. An electroluminescent device comprising an anode, cathode, and the emissive layer according to claim 7 disposed between the anode and cathode.

9. The electroluminescent device according to claim 8, wherein the emissive layer comprises a Thermally Activated Delayed Fluorescence (TADF) compound.

10. The device according to claim 8 or 9, wherein the emissive layer comprises the TADF compound selected from: DBA-DI, DBA-DmlCz, DBA-DTMCz, TDBA-Ac, DBA-SAB, DBA-SAF, 3CzTB, TMCz-BO, TMCZ-3P, CNICCz, CNICtCz, M3CzB, MCz-BOBO, MCz-BSBS, CNBPCz, DMAC-DPS, DMA-ThX, DMTDAc, CzBPCN, TXADO-spiro-DMACF, MPAc-BN, MPAc-BS, MPAc-BO, MPAc-DiP-BS, PXZN-B, DMACN-B, PPCzTrz, sAc-DBB, sAc-sDBB, 4CzBN, 4TCzBN and 5CzBN.

11. A use of the device according to any one claim 8 - 10 as a display screen or illumination device, an electroluminescent display device, an organic photovoltaic device, or a sensing device.

12. A consumer product comprising the device according to any one claim 8 - 10, wherein the product is selected from a flat panel display, a computer monitor, a medical monitor, a television, a billboard, a light for interior or exterior illumination/signalling, a heads-up display, a fully or partially transparent display, a flexible display, a laser printer, a telephone, a cell phone, tablet, a phablet, a personal digital assistant, a wearable device, a laptop computer, a watch, a backlight, a digital camera, a camcorder, a 3-D display, a virtual reality or augmented reality display, a vehicle, a video walls comprising multiple displays tiled together, a theatre, stadium screen, and a sign.
